# EUROPÄISCHE PATENTSCHRIFT

(11) **EP 3 328 872 B1**
(45) Veröffentlichungstag und Bekanntmachung des Hinweises auf die Patenterteilung: **29.05.2019**
(21) Anmeldenummer: 16736382.9
(22) Anmeldetag: 04.07.2016
(51) Int. Cl.: C07F 15/00, C09K 11/87, H01L 51/50, H05B 33/14, C09K 11/06, H01L 51/00

(54) **ELEKTROLUMINESZIERENDE ÜBERBRÜCKTE METALLKOMPLEXE ZUR VERWENDUNG IN ELEKTRONISCHEN VORRICHTUNGEN**
ELECTROLUMINESCENT BRIDGED METAL COMPLEXES FOR USE IN ELECTRONIC DEVICES
COMPLEXES MÉTALLIQUES ÉLECTROLUMINESCENTS PONTÉS DESTINÉS À ÊTRE UTILISÉS DANS DES DISPOSITIFS ÉLECTRONIQUES

(30) Priorität: 30.07.2015 EP 15178985
(43) Veröffentlichungstag der Anmeldung: 06.06.2018
(73) Patentinhaber: Merck Patent GmbH, 64293 Darmstadt (DE)
(72) Erfinder: STOESSEL, Philipp, 60389 Frankfurt am Main (DE); EHRENREICH, Christian, 64285 Darmstadt (DE)
(86) Internationale Anmeldenummer: PCT/EP2016/001143
(87) Internationale Veröffentlichungsnummer: WO 2017/016634

(56) Entgegenhaltungen:
- EP-A1- 1 400 514
- WO-A1-2014/094960
- WO-A1-2016/124304

## Beschreibung

Die vorliegende Erfindung betrifft Metallkomplexe, welche sich für den Einsatz als Emitter in organischen Elektrolumineszenzvorrichtungen eignen.

In organischen Elektrolumineszenzvorrichtungen (OLEDs), in denen organische Halbleiter als funktionelle Materialien eingesetzt werden, werden als emittierende Materialien häufig metallorganische Komplexe eingesetzt, die Phosphoreszenz statt Fluoreszenz zeigen. Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, immer noch Verbesserungsbedarf, insbesondere im Hinblick auf Effizienz, Betriebsspannung und Lebensdauer.

Dabei werden in phosphoreszierenden OLEDs als Triplettemitter vor allem Iridium- und Platinkomplexe eingesetzt. Als Iridiumkomplexe werden insbesondere bis- und tris-ortho-metallierte Komplexe mit aromatischen Liganden eingesetzt, wobei die Liganden über ein negativ geladenes Kohlenstoffatom und ein neutrales Stickstoffatom an das Metall binden. Beispiele für solche Komplexe sind Tris(phenylpyridyl)iridium(III) und Derivate davon. Aus der Literatur ist eine Vielzahl verwandter Liganden und Iridium- bzw. Platinkomplexe bekannt, wie beispielsweise Komplexe mit 1- oder 3-Phenylisochinolinliganden, mit 2-Phenyl-chinolinen oder mit Phenyl-chinoxalinen. Auch wenn mit derartigen Metallkomplexen bereits gute Ergebnisse erzielt werden, sind hier noch weitere Verbesserungen wünschenswert, insbesondere in Hinblick auf die Effizienz und die Lebensdauer der Komplexe.

Ein weiteres Problem, was manche der Metallkomplexe gemäß dem Stand der Technik aufweisen, ist die geringe Löslichkeit in organischen Lösemitteln. So ist beispielsweise Tris(benzo[h]chinolin)iridium(lll) in einer Vielzahl gängiger organischer Lösemittel, beispielsweise in aromatischen Kohlenwasserstoffen oder Chlorbenzol, nahezu unlöslich. Neben der dadurch erheblich erschwerten Aufreinigung bei der Herstellung der Komplexe wird durch die geringe Löslichkeit auch die Verwendung dieser Komplexe bei der lösungsprozessierten Herstellung der OLEDs erschwert oder gänzlich verhindert. Hier wäre daher der Zugang zu Derivaten mit höherer Löslichkeit wünschenswert, wobei sich durch die Derivatisierung deren elektronische Eigenschaften nicht verschlechtern sollten.

Verbesserungsbedarf gibt es weiterhin bei den Sublimationseigenschaften mancher Metallkomplexe gemäß dem Stand der Technik. So weisen diese eine hohe Sublimationstemperatur auf, was wiederum einen hohen thermischen Stress für diese Materialien sowohl bei der Sublimation zur Aufreinigung nach der Synthese wie auch bei der Herstellung von OLEDs in vakuumprozessierten Verfahren bedeutet. Hier wäre der Zugang zu Derivaten mit geringerer Sublimationstemperatur wünschenswert, wobei sich durch die Derivatisierung deren elektronische Eigenschaften nicht verschlechtern sollten.

Aufgabe der vorliegenden Erfindung ist daher die Bereitstellung neuer Metallkomplexe, welche sich als Emitter für die Verwendung in OLEDs eignen. Insbesondere ist die Aufgabe, Emitter bereitzustellen, welche verbesserte Eigenschaften in Bezug auf Effizienz, Betriebsspannung, Lebensdauer, Farbkoordinaten, Löslichkeit und/oder Oxidationsstabilität zeigen.

Überraschend wurde gefunden, dass bestimmte, unten näher beschriebene Metallchelatkomplexe diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Metallkomplexe, die spirocyklische Liganden enthalten, sind aus WO2014094960 bekannt. Die dort offenbarten Komplexe werden ebenfalls für elektronische Vorrichtungen verwendet.

Aus EP 1400514 sind Iridiumkomplexe mit Phenylpyridinliganden bekannt, bei denen die Phenylgruppe und die Pyridingruppe durch eine lineare oder verzweigte Alkylengruppe mit 2 bis 10 Kohlenstoffatomen miteinander verbrückt sind. Strukturen, bei denen die verbrückende Einheit eine Cycloalkylengruppe oder eine entsprechende bicyclische Einheit ist, sind nicht offenbart. Die offenbarten Strukturen haben einen deutlichen Torsionswinkel von ca. 15-25° zwischen der Pyridingruppe und der Phenylgruppe. Für eine optimale Koordination an das Metall und damit eine höhere Stabilität des Komplexes sollte der Torsionswinkel jedoch möglichst klein sein und bevorzugt 0° oder näherungsweise 0° betragen.

Gegenstand der Erfindung ist eine Verbindung gemäß Formel (1),

M(L)n(L')m Formel (1)

welche eine Teilstruktur M(L)ₙ der Formel (2) enthält: 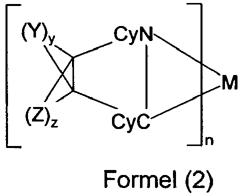 wobei für die verwendeten Symbole und Indizes gilt:
- M: ist Iridium oder Platin;
- CyC: ist eine Struktur der folgenden Formel (CyC): 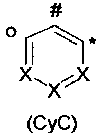 wobei die Gruppe an der durch # gekennzeichneten Position an CyN bindet und an der durch * gekennzeichneten Position an M koordiniert und die bicyclische Gruppe, die nachfolgend durch Formel (3) beschrieben wird, an der durch o gekennzeichneten Position an CyC gebunden ist:
- CyN: ist eine Struktur der folgenden Formel (CyN): 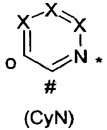 wobei die Gruppe an der durch # gekennzeichneten Position an CyC bindet und an der durch * gekennzeichneten Position an M koordiniert und die bicyclische Gruppe, die nachfolgend durch Formel (3) beschrieben wird, an der durch o gekennzeichneten Position an CyN gebunden ist;
- X: ist bei jedem Auftreten gleich oder verschieden CR oder N, mit der Maßgabe, dass maximal zwei Symbole X in CyC und maximal zwei Symbole X in CyN für N stehen;
- Y: ist bei jedem Auftreten gleich oder verschieden CR₂ oder O mit der Maßgabe, dass für y > 1 keine Sauerstoffatome direkt aneinander gebunden sind;
- Z: ist bei jedem Auftreten gleich oder verschieden CR₂ oder O mit der Maßgabe, dass für z > 1 keine Sauerstoffatome direkt aneinander gebunden sind;
- R: ist bei jedem Auftreten gleich oder verschieden H, D, F, Cl, Br, I, N(R¹)₂, CN, NO₂, OH, COOR¹, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R¹ substituiert sein kann, wobei eine oder mehrere nicht benachbarte CH₂-Gruppen durch R¹C=CR¹, R¹C=N, C≡C, Si(R¹)₂, C=O, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann, oder eine Aralkyl- oder Heteroaralkylgruppe mit 5 bis 40 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei benachbarte Reste R auch miteinander ein mono- oder polycyclisches, aliphatisches, aromatisches oder heteroaromatisches Ringsystem bilden;
- R¹: ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², R²C=N, C≡C, Si(R²)₂, C=O, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarytaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches, aromatisches oder heteroaromatisches Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können; dabei können zwei oder mehrere Substituenten R² auch miteinander ein mono- oder polycyclisches Ringsystem bilden;
- L': ist gleich oder verschieden bei jedem Auftreten ein Ligand;
- y: ist bei jedem Auftreten gleich oder verschieden 1, 2, 3, 4, 5, 6, oder 7;
- z: ist bei jedem Auftreten gleich oder verschieden 1, 2, 3, 4, 5, 6 oder 7;
- n: ist 1, 2 oder 3;
- m: ist 0, 1, 2, 3 oder 4;
dabei können auch mehrere Liganden L miteinander oder L mit L' über eine Einfachbindung oder eine bivalente oder trivalente Brücke verknüpft sein und so ein tridentates, tetradentates, pentadentates oder hexadentates Ligandensystem aufspannen;
weiterhin kann auch ein Substituent R zusätzlich an M koordinieren.

Die Teilstruktur der Formel (2) weist daher die folgende Struktur auf:

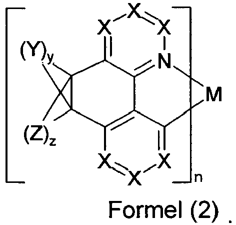

In der Struktur der Formel (2) sind CyC und CyN über eine kovalente Bindung miteinander verbunden. Weiterhin ist die Anwesenheit einer bicyclischen Brücke, die CyC und CyN zusätzlich miteinander verknüpft, erfindungswesentlich. Die Brücke weist erfindungsgemäß die Struktur der folgenden Formel (3) auf, 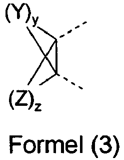 wobei die gestrichelte Bindung die Bindung an CyC bzw. CyN darstellt. Wenn Reste R, die an Y und/oder Z gebunden sind, miteinander ein Ringsystem bilden, wird aus der bicyclischen Struktur der Formel (3) eine polycyclische Struktur. Perspektivisch lässt sich die Brücke wie folgt darstellen:

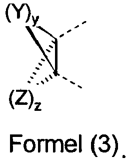

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Bevorzugt enthält die Heteroarylgruppe 1,2 oder 3 Heteroatome, von denen nicht mehr als eines ausgewählt ist aus O oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl oder Terphenyl, ebenfalls als. aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden. Wenn mehrere Substituenten miteinander ein aliphatisches Ringsystem bilden, so schließt der Begriff "aliphatisches Ringsystem" im Sinne der vorliegenden Erfindung auch heteroaliphatische Ringsysteme mit ein.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladung der Liganden L und L' so gewählt wird, dass sie die Ladung des komplexierten Metallatoms M kompensiert.

In den Komplexen der Formel (1) werden die Indizes n und m so gewählt, dass die Koordinationszahl am Metall M insgesamt, je nach Metall, der für dieses Metall üblichen Koordinationszahl entspricht. Dies ist für Iridium(III) die Koordinationszahl 6 und für Platin(II) die Koordinationszahl 4.

In einer bevorzugten Ausführungsform der Erfindung ist M Iridium(III), und der Index n steht für 1, 2 oder 3, bevorzugt für 2 oder 3. Wenn der Index n = 1 ist, sind noch vier monodentate oder zwei bidentate oder ein bidentater und zwei monodentate oder ein tridentater und ein monodentater oder ein tetradentater Ligand L', bevorzugt zwei bidentate Liganden L', an das Metall koordiniert. Wenn der Index n = 2 ist, sind noch ein bidentater oder zwei monodentate Liganden L', bevorzugt ein bidentater Ligand L', an das Metall koordiniert. Wenn der Index n = 3 ist, ist der Index m = 0.

In einer weiteren bevorzugten Ausführungsform der Erfindung ist M Platin(ll), und der Index n steht für 1 oder 2. Wenn der Index n = 1 ist, sind noch ein bidentater oder zwei monodentate Liganden L', bevorzugt ein bidentater Ligand L', an das Metall M koordiniert. Wenn der Index n = 2 ist, ist der Index m = 0.

In einer bevorzugten Ausführungsform der Erfindung steht in der Gruppe der Formel (CyC) maximal ein X für N und die beiden anderen Gruppen X stehen für CR. Besonders bevorzugt stehen in der Gruppe der Formel (CyC) alle Gruppen X für CR.

Bevorzugte Ausführungsformen der Gruppe CyC sind die Strukturen der folgenden Formeln (CyC-1) bis (CyC-5), wobei die Gruppen jeweils an der durch # gekennzeichneten Position an CyN binden und an der durch * gekennzeichneten Position an M koordinieren und die bicyclische Gruppe der Formel (3) an der durch o gekennzeichneten Position gebunden ist, 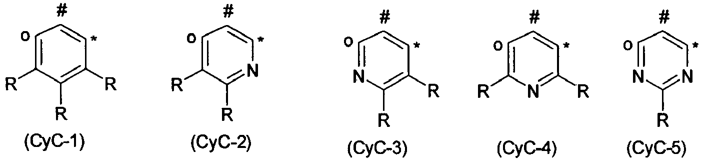 wobei R die oben genannten Bedeutungen aufweist.

Wie oben beschrieben, können benachbarte Reste R auch miteinander ein aliphatisches, aromatisches oder heteroaromatisches Ringsystem aufspannen. Bevorzugte Gruppen CyC, die sich in den Fällen (CyC-1b) bis (CyC-1k) durch Ringbildung der Reste R ergeben, sind die im Folgenden aufgeführten Gruppen (CyC-1a) bis (CyC-1k) und (CyC-2a) bis (CyC-5a), 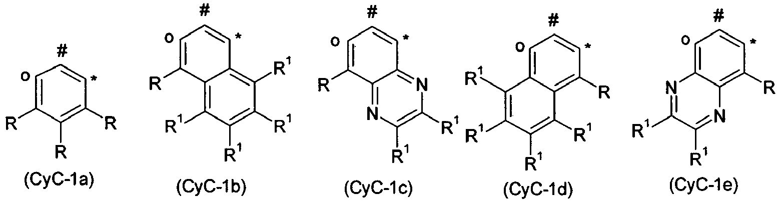 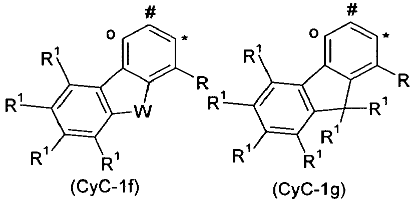 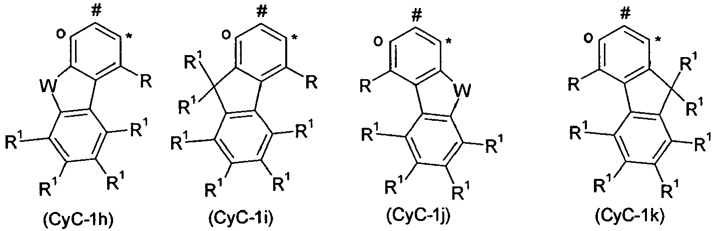 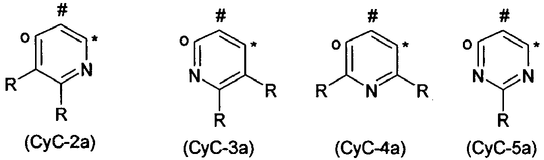 wobei die verwendeten Symbole die oben genannten Bedeutungen aufweisen, W bei jedem Auftreten gleich oder verschieden für NR¹, O oder S steht und die Reste R und R¹ bevorzugt kein aromatisches oder heteroaromatisches Ringsystem miteinander bilden.

Besonders bevorzugt sind die Gruppen (CyC-1a), (CyC-1b), (CyC-1f), (CyC-1h) und (CyC-1i), und ganz besonders bevorzugt ist die Gruppe (CyC-1a).

In einer bevorzugten Ausführungsform der Erfindung steht in der Gruppe der Formel (CyN) maximal ein X für N und die beiden anderen Gruppen X stehen für CR. Besonders bevorzugt stehen in der Gruppe der Formel (CyN) alle Gruppen X für CR.

Bevorzugte Ausführungsformen der Gruppe CyN sind die Strukturen der folgenden Formeln (CyN-1) bis (CyN-4), wobei die Gruppen jeweils an der durch # gekennzeichneten Position an CyC binden und an der durch * gekennzeichneten Position an M koordinieren und die bicyclische Gruppe der Formel (3) an der durch o gekennzeichneten Position an CyN gebunden ist, 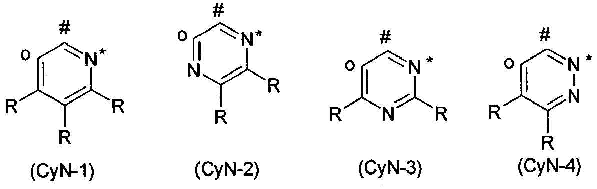 wobei R die oben genannten Bedeutungen aufweist.

Wie oben beschrieben, können benachbarte Reste R auch miteinander ein aliphatisches, aromatisches oder heteroaromatisches Ringsystem aufspannen. Bevorzugte Gruppen CyN, die sich in den Fällen (CyN-1b), (CyN-1c) und (CyN-2a) durch Ringbildung der Reste R ergeben, sind die im Folgenden aufgeführten Gruppen (CyN-1a) bis (CyN-1c) und (CyN-2a), 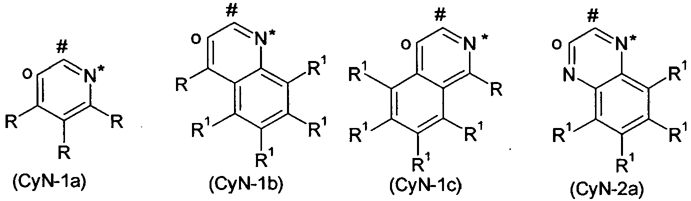 wobei die verwendeten Symbole die oben genannten Bedeutungen aufweisen und die Reste R und R¹ bevorzugt kein aromatisches oder heteroaromatisches Ringsystem miteinander bilden.

Bevorzugte Gruppen sind die Gruppen (CyN-1a), (CyN-1b) und (CyN-1c).

Die oben genannten bevorzugten Gruppen CyC und CyN können beliebig miteinander kombiniert werden. Geeignet sind im Liganden L insbesondere die folgenden Kombinationen aus CyC und CyN:

| Nr. | CyC | CyN |
|---|---|---|
| 1 | CyC-1 | CyN-1 |
| 2 | CyC-1 | CyN-2 |
| 3 | CyC-1 | CyN-3 |
| 4 | CyC-2 | CyN-1 |
| 5 | CyC-2 | CyN-2 |
| 6 | CyC-2 | CyN-3 |
| 7 | CyC-3 | CyN-1 |
| 8 | CyC-3 | CyN-2 |
| 9 | CyC-3 | CyN-3 |
| 10 | CyC-4 | CyN-1 |
| 11 | CyC-4 | CyN-2 |
| 12 | CyC-4 | CyN-3 |
| 13 | CyC-5 | CyN-1 |
| 14 | CyC-5 | CyN-2 |
| 15 | CyC-5 | CyN-3 |

Insbesondere bevorzugt ist es, wenn die oben als besonders bevorzugt genannten Gruppen CyC und CyN miteinander kombiniert werden. Besonders bevorzugt sind somit im Liganden L die folgenden Kombinationen aus CyC und CyN:

| Nr. | CyC | CyN |
|---|---|---|
| 1 | CyC-1a | CyN-1a |
| 2 | CyC-1a | CyN-1b |
| 3 | CyC-1a | CyN-1c |
| 4 | CyC-1b | CyN-1a |
| 5 | CyC-1b | CyN-1b |
| 6 | CyC-1b | CyN-1c |
| 7 | CyC-1f | CyN-1a |
| 8 | CyC-1f | CyN-1b |
| 9 | CyC-1f | CyN-1c |
| 10 | CyC-1h | CyN-1a |
| 11 | CyC-1h | CyN-1b |
| 12 | CyC-1h | CyN-1c |
| 13 | CyC-1i | CyN-1a |
| 14 | CyC-1i | CyN-1b |
| 15 | CyC-1i | CyN-1c |

Ganz besonders bevorzugt ist die Struktur der Formel (2) eine Struktur der folgenden Formel (2a), 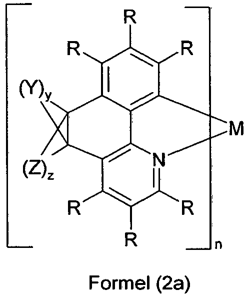 wobei die verwendeten Symbole und Indizes die oben genannten Bedeutungen aufweisen.

Wenn X für CR steht, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei bevorzugt benachbarte Rest R oder R mit R¹ auch miteinander ein Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 6 bis 13 aromatischen Ringatomen, das jeweils durch einen oder mehrere Reste R¹ substituiert sein kann; dabei können zwei benachbarte Reste R oder R mit R¹ auch miteinander ein Ringsystem bilden. Dieselbe Bevorzugung gilt für die in Formel (2a) abgebildeten Reste R an der Phenylpyridinligandenstruktur.

Bevorzugte Reste R¹ sind bei jedem Auftreten gleich oder verschieden H, D, F, eine geradkettige Alkyl- oder Alkoxygruppe mit 1 bis 10 C-Atomen oder eine Alkenylgruppe mit 2 bis 20 C-Atomen oder eine verzweigte oder cyclische Alkyl- oder Alkoxygruppe mit 3 bis 10 C-Atomen, die jeweils mit einem oder mehreren Resten R² substituiert sein kann, wobei ein oder mehrere H-Atome durch F ersetzt sein können, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches, aromatisches oder heteroaromatisches Ringsystem bilden. Besonders bevorzugte Reste R¹ sind bei jedem Auftreten gleich oder verschieden H, D, F, eine geradkettige Alkylgruppe mit 1 bis 4 C-Atomen oder eine verzweigte oder cyclische Alkylgruppe mit 3 bis 6 C-Atomen oder ein aromatisches oder heteroaromatisches Ringsystem mit 6 bis 13 aromatischen Ringatomen, das jeweils durch einen oder mehrere Reste R² substituiert sein kann, bevorzugt aber unsubstituiert ist; dabei können zwei oder mehrere benachbarte Reste R¹ miteinander ein mono- oder polycyclisches, aliphatisches, aromatisches oder heteroaromatisches Ringsystem bilden.

Wie oben beschrieben, ist es erfindungswesentlich, dass CyN und CyC bzw. die oben aufgeführten bevorzugten Ausführungsformen durch eine bicyclische Gruppe der Formel (3) verbrückt sind, für die im Folgenden bevorzugte Ausführungsformen ausgeführt werden:

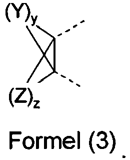

Bei der Gruppe der Formel (3) handelt es sich um bicyclische Strukturen, wobei durch Ringbildung der Substituenten an dieser Struktur auch eine polycyclische Struktur entstehen kann. Durch die bicyclische Struktur weist die Gruppe der Formel (3) keine benzylischen Protonen auf. Dies ist von Vorteil, da benzylische Protonen durch ihre erhöhte Reaktivität die Stabilität der Metallkomplexe herabsetzen.

In einer bevorzugten Ausführungsform der Erfindung stehen Y und Z gleich oder verschieden bei jedem Auftreten für CR₂ oder O, wobei für y ≥ 2 maximal zwei Y in der Gruppe (Y)_{y} und für z ≥ 2 maximal zwei Z in der Gruppe (Z)_{z} für O stehen. Besonders bevorzugt steht maximal ein Y in der Gruppe (Y)_{y} und maximal ein Z in der Gruppe (Z)_{z} für O. Ganz besonders bevorzugt stehen Y und Z gleich oder verschieden bei jedem Auftreten für CR₂. In einer ganz besonders bevorzugten Ausführungsform handelt es sich somit um eine rein aliphatische Gruppe und nicht um eine heteroaliphatische Gruppe.

In einer weiteren bevorzugten Ausführungsform der Erfindung stehen y und z gleich oder verschieden bei jedem Auftreten für 1, 2, 3, 4 oder 5, besonders bevorzugt für 1, 2, 3 oder 4, und ganz besonders bevorzugt für 2, 3 oder 4. Dabei sind verschiedene Kombinationen von y und z möglich. Beispiele für geeignete Kombinationen der Indizes y und z sind in der folgenden Tabelle angegeben:

| y | z |
|---|---|
| 2 | 2 |
| 2 | 3 |
| 3 | 3 |
| 3 | 4 |
| 4 | 4 |

Wenn Y und/oder Z für CR₂ stehen, sind diese Reste R gleich oder verschieden bei jedem Auftreten ausgewählt aus der Gruppe bestehend aus H, D, F, einer geradkettigen Alkylgruppe mit 1 bis 10 C-Atomen, die mit einem oder mehreren Resten R¹ substituiert sein kann, bevorzugt aber unsubstituiert ist, einer verzweigten oder cyclischen Alkylgruppe mit 3 bis 10 C-Atomen, die mit einem oder mehreren Resten R¹ substituiert sein kann, bevorzugt aber unsubstituiert ist, oder einem aromatischen oder heteroaromatischen Ringsystem mit 6 bis 13 aromatischen Ringatomen, das jeweils durch einen oder mehrere Reste R¹ substituiert sein kann; dabei können zwei oder mehrere Reste R auch miteinander ein Ringsystem bilden. Besonders bevorzugt sind die Reste R gleich oder verschieden bei jedem Auftreten gewählt aus der Gruppe bestehend aus H, F, einer geradkettigen Alkylgruppe mit 1 bis 4 C-Atomen, einer verzweigten Alkylgruppe mit 3 oder 4 C-Atomen oder einer Phenylgruppe, die durch eine Alkylgruppe mit 1 bis 4 C-Atomen substituiert sein kann, bevorzugt aber unsubstituiert ist; dabei können zwei oder mehrere Reste R auch miteinander ein Ringsystem bilden.

Bevorzugte Reste R¹ sind die gleichen, wie sie oben bereits ausgeführt sind.

Wenn die Reste R an Y und/oder Z miteinander ein Ringsystem bilden, entstehen dadurch polycyclische Strukturen.

Beispiele für geeignete bicyclische Strukturen der Formel (3) sind die im Folgenden aufgeführten Strukturen der Formeln (3a) bis (3e), und Beispiele für geeignete polycyclische Strukturen der Formel (3) sind die im Folgenden aufgeführten Strukturen der Formeln (3f) bis (3q),

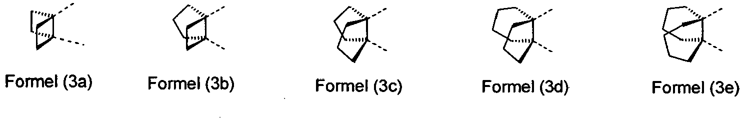

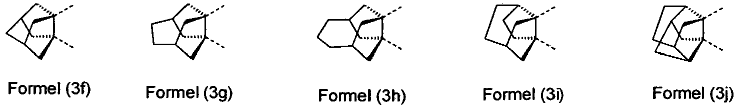

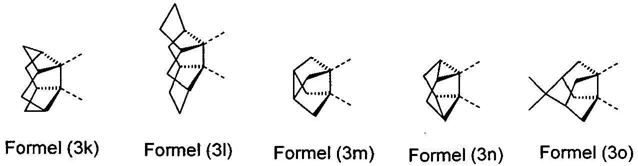

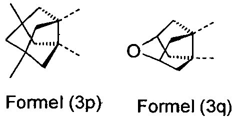

Diese Gruppen können auch durch ein oder mehrere Reste R substituiert sein, wobei R bevorzugt für eine Alkylgruppe mit 1 bis 4 C-Atomen steht. Bevorzugt sind diese Gruppen aber unsubstituiert.

In einer weiteren Ausführungsform der Erfindung ist ein Substituent R, der an den koordinierenden Aryl- bzw. Heteroarylgruppen CyC oder CyN in der ortho-Position zur Metallkoordination gebunden ist, eine Gruppe, die ebenfalls an das Metall M koordiniert. Bevorzugte koordinierende Gruppen R sind Aryl- bzw. Heteroarylgruppen, beispielsweise Phenyl oder Pyridyl, Aryl- oder Alkylcyanide, Aryl- oder Alkylisocyanide, Amine oder Amide, Alkohole oder Alkoholate, Thioalkohole oder Thioalkoholate, Phosphine, Phosphite, Carbonylfunktionen, Carboxylate, Carbamide oder Aryl- oder Alkylacetylide.

Wie oben beschrieben, kann auch statt einem Rest R an den koordinierenden Aryl- bzw. Heteroarylgruppen CyC bzw. CyN auch eine verbrückende Einheit vorhanden sein, die den Liganden L mit einem oder mehreren weiteren Liganden L bzw. L' verknüpft. In einer bevorzugten Ausführungsform der Erfindung ist statt einem der Reste R, die an CyC oder CyN in ortho- oder meta-Position zum koordinierenden Atom stehen, eine verbrückende Einheit vorhanden, so dass die Liganden dreizähnigen oder mehrzähnigen oder polypodalen Charakter aufweisen. Es können auch zwei solcher verbrückenden Einheiten vorhanden sein. Dies führt zur Bildung makrocyclischer Liganden bzw. zur Bildung von Kryptaten.

Bevorzugte Strukturen mit mehrzähnigen Liganden bzw. mit polydentaten Liganden sind die Metallkomplexe der folgenden Formeln (4) bis (9), 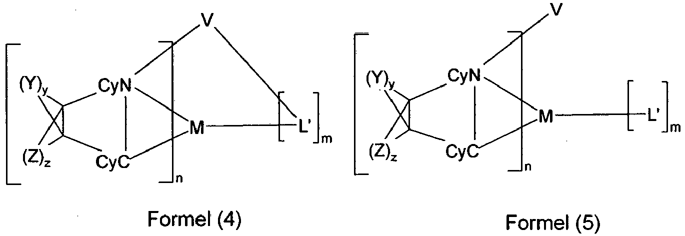 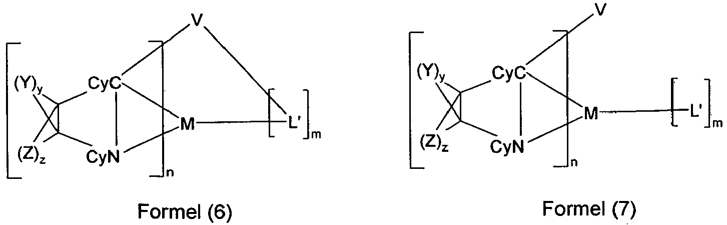 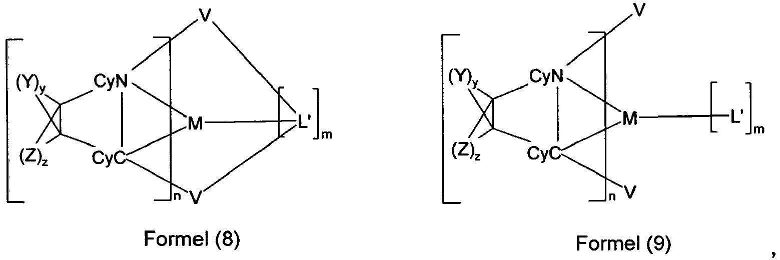 wobei die verwendeten Symbole und Indizes die oben genannten Bedeutungen aufweisen.

Dabei stellt in den Strukturen der Formeln (4) bis (9) V bevorzugt eine Einfachbindung oder eine verbrückende Einheit dar, enthaltend 1 bis 80 Atome aus der dritten, vierten, fünften und/oder sechsten Hauptgruppe (Gruppe 13, 14, 15 oder 16 gemäß IUPAC) oder einen 3- bis 6-gliedrigen Homo- oder Heterocyclus, die die Teilliganden L miteinander oder L mit L' miteinander kovalent verbindet. Dabei kann die verbrückende Einheit V auch unsymmetrisch aufgebaut sein, d. h. die Verknüpfung von V zu L bzw. L' muss nicht identisch sein. Die verbrückende Einheit V kann neutral, einfach, zweifach oder dreifach negativ oder einfach, zweifach oder dreifach positiv geladen sein. Bevorzugt ist V neutral oder einfach negativ oder einfach positiv geladen, besonders bevorzugt neutral. Dabei wird die Ladung von V bevorzugt so gewählt, dass insgesamt ein neutraler Komplex entsteht. Dabei gelten für die Liganden die oben für die Teilstruktur MLₙ genannten Bevorzugungen und n ist bevorzugt mindestens 2.

Die genaue Struktur und chemische Zusammensetzung der Gruppe V hat keinen wesentlichen Einfluss auf die elektronischen Eigenschaften des Komplexes, da die Aufgabe dieser Gruppe im Wesentlichen darin liegt, durch die Verbrückung von L miteinander bzw. mit L' die chemische und thermische Stabilität der Komplexe zu erhöhen.

Wenn V eine trivalente Gruppe ist, also drei Liganden L miteinander bzw. zwei Liganden L mit L' oder einen Liganden L mit zwei Liganden L' verbrückt, ist V bevorzugt gleich oder verschieden bei jedem Auftreten gewählt aus der Gruppe bestehend aus B, B(R¹)⁻, B(C(R¹)₂)₃, (R¹)B(C(R¹)₂)₃⁻, B(O)₃, (R¹)B(O)₃⁻, B(C(R¹)₂C(R¹)₂)₃, (R¹)B(C(R¹)₂C(R¹)₂)₃⁻, B(C(R¹)₂O₃, (R¹)B(C(R¹)₂O)₃⁻, B(OC(R¹)₂)₃, (R¹)B(OC(R¹)₂)₃⁻, C(R¹), CO-, CN(R¹)₂, (R¹)C(C(R¹)₂)₃, (R¹)C(O)₃, (R¹)C(C(R¹)₂C(R¹)₂)₃, (R¹)C(C(R¹)₂O)₃, (R¹)C(OC(R¹)₂)₃, (R¹)C(Si(R¹)₂)₃, (R¹)C(Si(R¹)₂C(R¹)₂)₃, (R¹)C(C(R¹)₂Si(R¹)₂)₃, (R¹)C(Si(R¹)₂Si(R¹)₂)₃, Si(R¹), (R¹)Si(C(R¹)₂)₃, (R¹)Si(O)₃, (R¹)Si(C(R¹)₂C(R¹)2)3, (R¹)Si(OC(R¹)₂)₃, (R¹)Si(C(R¹)₂O)₃, (R¹)Si(Si(R¹)₂)₃, (R¹)Si(Si(R¹)₂C(R¹)₂)₃, (R¹)Si(C(R¹)₂Si(R¹)₂)₃, (R¹)Si(Si(R¹)2Si(R¹)2)3, N, NO, N(R¹)⁺, N(C(R¹)₂)₃, (R¹)N(C(R¹)2)3⁺, N(C=O)₃, N(C(R¹)₂C(R¹)₂)₃, (R¹)N(C(R¹)₂C(R¹)₂)⁺, P, P(R¹)⁺, PO, PS, P(O)₃, PO(O)₃, P(OC(R¹)₂)₃, PO(OC(R¹)₂)₃, P(C(R¹)₂)₃, P(R¹)(C(R¹)₂)₃⁺, PO(C(R¹)₂)₃, P(C(R¹)₂C(R¹)₂)₃, P(R¹) (C(R¹)₂C(R¹)₂)₃⁺, PO(C(R¹)₂C(R¹)₂)₃, S⁺, S(C(R¹)₂)₃⁺, S(C(R¹)₂C(R¹)₂)₃⁺,
oder eine Einheit gemäß Formel (10) bis (15), 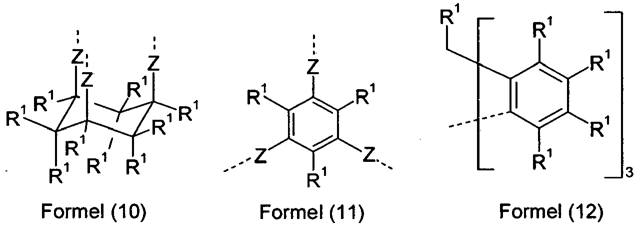 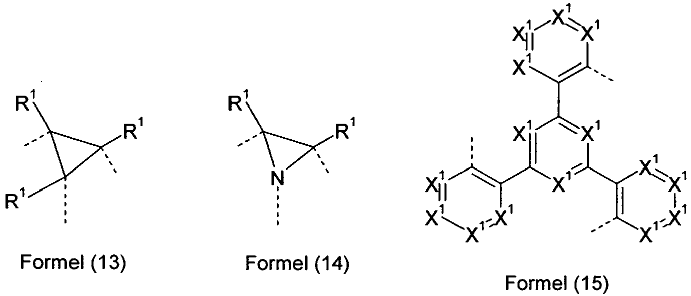 wobei die gestrichelten Bindungen jeweils die Bindung zu den Teilliganden L bzw. L' andeuten und Z gleich oder verschieden bei jedem Auftreten ausgewählt ist aus der Gruppe bestehend aus einer Einfachbindung, O, S, S(=O), S(=O)₂, NR¹, PR¹, P(=O)R¹, C(R¹)₂, C(=O), C(=NR¹), C(=C(R¹)₂), Si(R¹)₂ oder BR¹ und X¹ gleich oder verschieden bei jedem Auftreten für CR¹ oder N steht, wobei nicht mehr als drei X¹ pro Cyclus für N stehen. Die weiteren verwendeten Symbole haben die oben genannten Bedeutungen.

Wenn V eine bivalente Gruppe ist, also zwei Liganden L miteinander bzw. einen Liganden L mit L' verbrückt, ist V bevorzugt gleich oder verschieden bei jedem Auftreten gewählt aus der Gruppe bestehend aus BR¹, B(R¹)₂⁻, C(R¹)₂, C(=O), Si(R¹)_{2,} NR¹, PR¹, P(R¹)₂⁺, P(=O)(R¹), P(=S)(R¹), O, S, Se, oder eine Einheit gemäß Formel (16) bis (25), 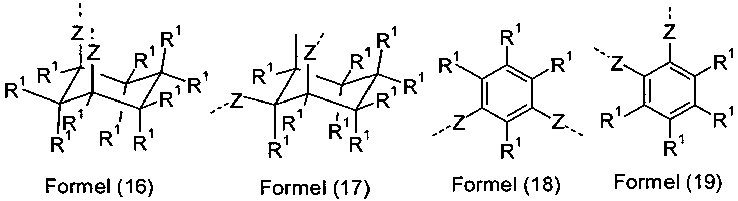 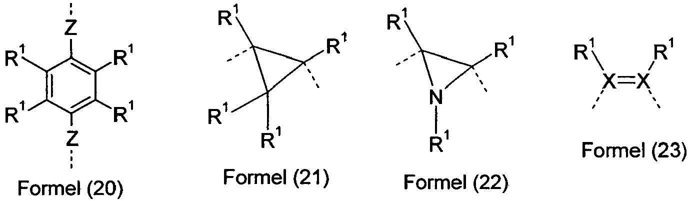 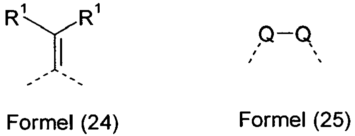 wobei die gestrichelten Bindungen jeweils die Bindung zu den Teilliganden L bzw. L' andeuten, Q bei jedem Auftreten gleich oder verschieden für C(R¹)₂, N(R¹), O oder S steht und die weiteren verwendeten Symbole jeweils die oben aufgeführten Bedeutungen haben.

Im Folgenden werden bevorzugte Liganden L' beschrieben, wie sie in Formel (1) vorkommen. Entsprechend können auch die Ligandengruppen L' gewählt sein, wenn diese über eine verbrückende Einheit V an L gebunden sind, wie in Formeln (4), (6) und (8) angedeutet.

Die Liganden L' sind bevorzugt neutrale, monoanionische, dianionische oder trianionische Liganden, besonders bevorzugt neutrale oder monoanionische Liganden. Sie können monodentat, bidentat, tridentat oder tetradentat sein und sind bevorzugt bidentat, weisen also bevorzugt zwei Koordinationsstellen auf. Wie oben beschrieben, können die Liganden L' auch über eine verbrückende Gruppe V an L gebunden sein. Besonders bevorzugt sind die Liganden L' bidentat und monoanionisch.

Bevorzugte neutrale, monodentate Liganden L' sind ausgewählt aus der Gruppe bestehend aus Kohlenmonoxid, Stickstoffmonoxid, Alkylcyaniden, wie z. B. Acetonitril, Arylcyaniden, wie z. B. Benzonitril, Alkylisocyaniden, wie z. B. Methylisonitril, Arylisocyaniden, wie z. B. Benzoisonitril, Aminen, wie z. B. Trimethylamin, Triethylamin, Morpholin, Phosphinen, insbesondere Halogenphosphine, Trialkylphosphine, Triarylphosphine oder Alkylarylphosphine, wie z. B. Trifluorphosphin, Trimethylphosphin, Tricyclohexylphosphin, Tri-*tert*-butylphosphin, Triphenylphosphin, Tris(pentafluorphenyl)phosphin, Dimethylphenylphosphin, Methyldiphenylphosphin, Bis(tert-butyl)phenylphosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin, Tris(pentafluorphenyl)arsin, Stibinen, wie z. B. Trifluorstibin, Trimethylstibin, Tricyclohexylstibin, Tri-*tert-*butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen.

Bevorzugte monoanionische, monodentate Liganden L'sind ausgewählt aus Hydrid, Deuterid, den Halogeniden F⁻, Cl⁻, Br⁻ und I⁻, Alkylacetyliden, wie z. B. Methyl-C≡C⁻, tert-Butyl-C≡C⁻, Arylacetyliden, wie z. B. Phenyl-C≡C⁻, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*i*so-propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt C₁-C₂₀-Alkylgruppen, besonders bevorzugt C₁-C₁₀-Alkylgruppen, ganz besonders bevorzugt C₁-C₄-Alkylgruppen. Unter einer Arylgruppe werden auch Heteroarylgruppen verstanden. Diese Gruppen sind wie oben definiert.

Bevorzugte di- bzw. trianionische Liganden sind O²⁻, S²⁻, Carbide, welche zu einer Koordination der Form R-C=M führen, und Nitrene, welche zu einer Koordination der Form R-N=M führen, wobei R allgemein für einen Substituenten steht, oder N³⁻.

Bevorzugte neutrale oder mono- oder dianionische, bidentate oder höherdentate Liganden L'sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2-[1-(Phenylimino)ethyl]pyridin, 2-[1-(2-Methylphenylimino)ethyl]pyridin, 2-[1-(2,6-Di-*i*so-propylphenylimino)ethyl]pyridin, 2-[1-(Methylimino)ethyl]pyridin, 2-[1-(ethylimino)ethyl]pyridin, 2-[1-(*I*so-Propylimino)ethyl]pyridin, 2-[1-(*Tert-*Butylimino)ethyl]pyridin, Diiminen, wie z. B. 1,2-Bis(methylimino)ethan, 1,2-Bis(ethylimino)ethan, 1,2-Bis(*iso*-propylimino)ethan, 1,2-Bis(*tert*-butyl-imino)ethan, 2,3-Bis(methylimino)butan, 2,3-Bis(ethylimino)butan, 2,3-Bis-(*iso*-propylimino)butan, 2,3-Bis(*tert*-butylimino)butan, 1,2-Bis(phenylimino)-ethan, 1,2-Bis(2-methylphenylimino)ethan, 1,2-Bis(2,6-di-*iso*-propylphenyl-imino)ethan, 1,2-Bis(2,6-di-*tert*-butylphenylimino)ethan, 2,3-Bis(phenyl-imino)butan, 2,3-Bis(2-methylphenylimino)butan, 2,3-Bis(2,6-di-*iso*-propyl-phenylimino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenylphosphino)ethan, Bis(diphenylphosphino)propan, Bis(di-phenylphosphino)butan, Bis(dimethylphosphino)methan, Bis(dimethyl-phosphino)ethan, Bis(dimethylphosphino)propan, Bis(diethylphosphino)-methan, Bis(diethylphosphino)ethan, Bis(diethylphosphino)propan, Bis(di-*tert*-butylphosphino)methan, Bis(di-*tert*-butylphosphino)ethan, Bis(*tert-*butylphosphino)propan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethylamino-alanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol, Dithiolaten abgeleitet von Dithiolen, wie z. B. 1,2-Ethylendithiol, 1,3-Propylendithiol, Bis(pyrazolylboraten), Bis(imidazolyl)boraten, 3-(2-Pyridyl)-diazolen oder 3-(2 -Pyridyl)-triazolen.

Bevorzugte tridentate Liganden sind Borate stickstoffhaltiger Heterocyclen, wie z. B. Tetrakis(1-imidazolyl)borat und Tetrakis(1-pyrazolyl)borat.

Bevorzugt sind weiterhin bidentate monoanionische, neutrale oder dianionische Liganden L', insbesondere monoanionische Liganden, welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (26) bis (50) dargestellt sind, wobei eine Gruppe bevorzugt über ein neutrales Stickstoffatom oder ein Carbenkohlenstoffatom bindet und die andere Gruppe bevorzugt über ein negativ geladenes Kohlenstoffatom oder ein negativ geladenes Stickstoffatom bindet. Der Ligand L' kann dann aus den Gruppen der Formeln (26) bis (50) gebildet werden, indem diese Gruppen jeweils an der durch # gekennzeichneten Position aneinander binden. Die Position, an der die Gruppen an das Metall koordinieren, sind durch * gekennzeichnet. Diese Gruppen können auch über eine oder zwei verbrückende Einheiten V an den Liganden L gebunden sein.

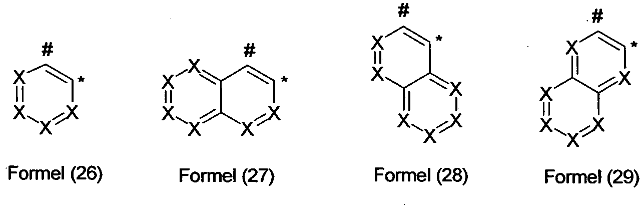

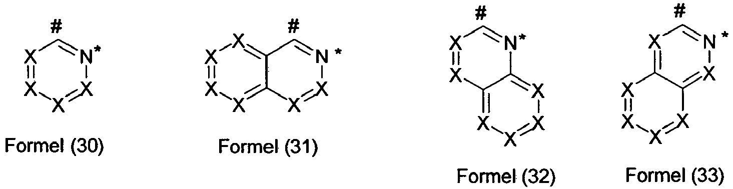

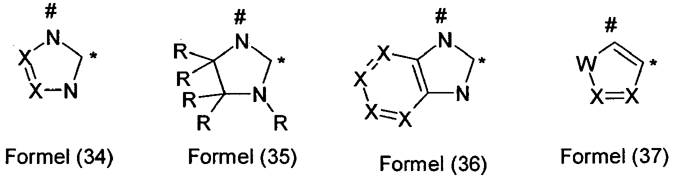

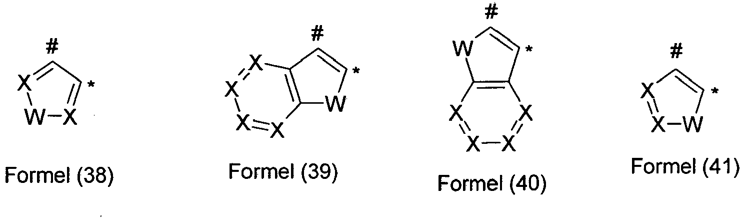

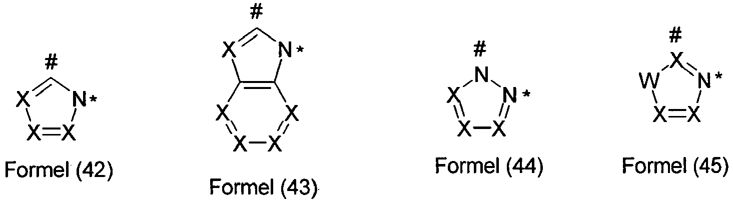

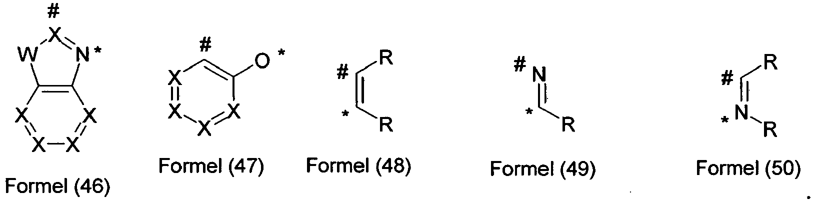

Dabei haben X, R und W die oben genannten Bedeutungen. Bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für CR.

Dabei kann durch Ringbildung von benachbarten Substituenten auch aus den beiden einzelnen Aryl- bzw. Heteroarylgruppen eine kondensierte Heteroarylgruppe entstehen, die als bidentater Ligand L' an M koordiniert. Beispiele hierfür sind die Liganden der folgenden Formeln (51), (52) und (53), 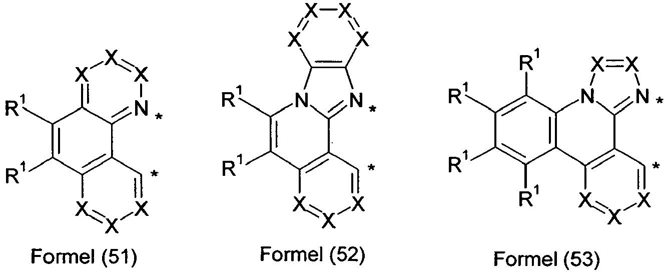 wobei die verwendeten Symbole die oben genannten Bedeutungen aufweisen.

Beispiele für geeignete Ausführungsformen des Liganden der Formel (52) können den Patentanmeldungen WO 2010/086089, WO 2011/157339 und WO 2014/008982 entnommen werden.

Weitere geeignete Co-Liganden L' sind Strukturen, welche nicht vollständig heteroaromatisch sind, sondern welche in der Ligandengrundstruktur eine Ketogruppe aufweisen, wie sie in WO 2011/044988, WO 2014/094962, WO 2014/094961 und WO 2014/094960 offenbart sind.

Beispiele für geeignete Co-Liganden L', bei denen die Reste an den einzelnen koordinierenden Gruppen miteinander ein Ringsystem bilden, sind in der folgenden Tabelle aufgeführt, wobei jeweils auch die CAS-Nummer angegeben ist:

| | | | |
|---|---|---|---|
| 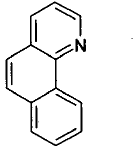 | 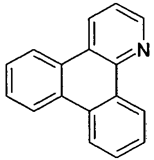 | 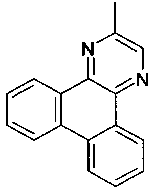 | 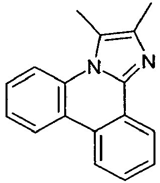 |
| 230-27 -3 | 217-65-2 | 536753-86-3 | 943454-10-2 |
| 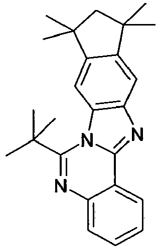 | 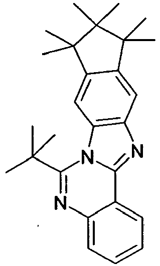 | 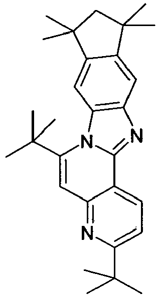 | 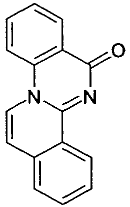 |
| 1541107-37-2 | 1541107-73-6 | 1541109-75-4 | 1615694-84-2 |
| 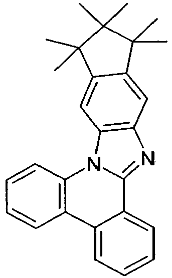 | 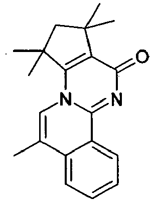 | 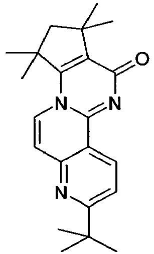 | 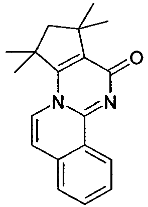 |
| 1541112-31-5 | 1616465-51-0 | 1615218-31-9 | 1616465-35-0 |
| 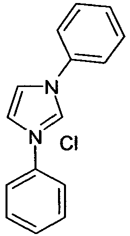 | 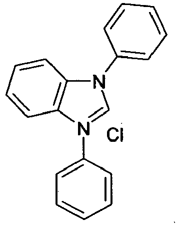 | 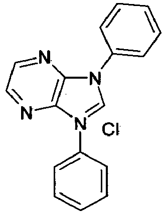 | 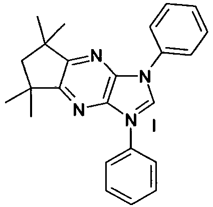 |
| 26956-10-5 | 868697-84-2 | 1501154-71-7 | 1311465-49-2 |

Ebenfalls bevorzugte Liganden L' sind η⁵-Cyclopentadienyl, η⁵-pentamethylcyclopentadienyl, η⁶-Benzol oder η⁷-Cycloheptatrienyl, welche jeweils durch einen oder mehrere Reste R substituiert sein können.

Ebenfalls bevorzugte Liganden L' sind 1,3,5-cis,cis-Cyclohexanderivate, insbesondere der Formel (54), 1,1,1-Tri(methylen)methanderivate, insbesondere der Formel (55) und 1,1,1-trisubstituierte Methane, insbesondere der Formel (56) und (57), 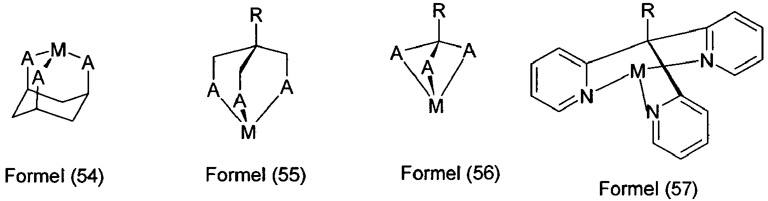 wobei in den Formeln jeweils die Koordination an das Metall M dargestellt ist, R die oben genannte Bedeutung hat und A, gleich oder verschieden bei jedem Auftreten, für O⁻, S-, COO-, PR₂ oder NR₂ steht.

Wenn sich die Liganden L' aus den Strukturen der Formeln (26) bis (50) zusammensetzen, dann sind bevorzugte Reste R an diesen Strukturen dieselben, wie sie oben bereits für Formel (2) als Reste R ausgeführt sind, wenn X für CR steht.

In einer bevorzugten Ausführungsform der Erfindung koordiniert L' über eine oder mehrere aromatische bzw. heteroaromatische Gruppen an M, aber koordiniert nicht über nicht-aromatische und nicht-heteroaromatische Gruppen.

Die erfindungsgemäßen Komplexe können facial bzw. pseudofacial sein, oder sie können meridional bzw. pseudomeridional sein.

Die Liganden L können je nach Struktur auch chiral sein. Dies ist beispielsweise dann der Fall, wenn in der Struktur der Formel (3) die Gruppen (Y)_{y} und (Z)_{z} unterschiedlich sind oder wenn sie Substituenten enthalten, beispielsweise Alkyl-, Alkoxy, Dialkylamino- oder Aralkylgruppen, welche ein oder mehrere Stereozentren aufweisen. Da es sich bei der Grundstruktur des Komplexes auch um eine chirale Struktur handeln kann, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Die Verbindungen können auch als chirale, enantiomerenreine Komplexe eingesetzt werden, welche circular polarisiertes Licht emittieren können. Dies kann Vorteile aufweisen, da dadurch der Polarisationsfilter auf dem Device eingespart werden kann. Außerdem eignen sich solche Komplexe auch zur Verwendung in Sicherheitslabeln, da sie neben der Emission auch die Polarisation des Lichts als einfach auslesbares Merkmal aufweisen.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Ein weiterer Gegenstand der vorliegenden Erfindung ist ein Verfahren zur Herstellung der Metallkomplex-Verbindungen gemäß Formel (1) durch Umsetzung der entsprechenden freien Liganden L und gegebenenfalls L' mit Metallalkoholaten der Formel (58), mit Metallketoketonaten der Formel (59), mit Metallhalogeniden der Formel (60), mit dimeren Metallkomplexen der Formel (61) oder mit Metallkomplexen der Formel (62), 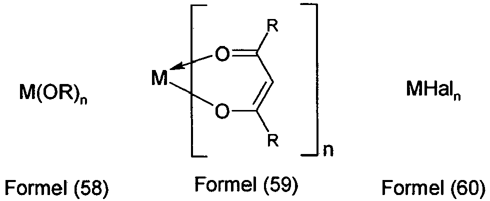 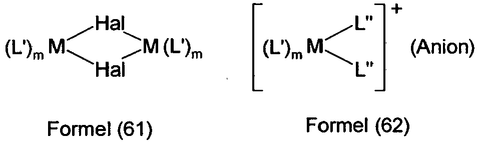 wobei die Symbole M, m, n und R die oben angegebenen Bedeutungen haben, Hal = F, Cl, Br oder I ist, L" für einen Alkohol, insbesondere für einen Alkohol mit 1 bis 4 C-Atomen oder ein Nitril, insbesondere Acetonitril oder Benzonitril, steht und (Anion) ein nicht-koordinierendes Anion ist, wie beispielsweise Triflat.

Es können ebenfalls Metallverbindungen, insbesondere Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht. Geeignete Platin-Edukte sind beispielsweise PtCl₂, K₂[PtCl₄], PtCl₂(DMSO)₂, Pt(Me)₂(DMSO)₂ oder PtCl₂(Benzonitril)₂.

Die Synthese der Komplexe wird bevorzugt durchgeführt wie in WO 2002/060910, WO 2004/085449 und WO 2007/065523 beschrieben. Heteroleptische Komplexe können beispielsweise auch gemäß WO 2005/042548 synthetisiert werden. Dabei kann die Synthese beispielsweise auch thermisch, photochemisch und/oder durch Mikrowellenstrahlung aktiviert werden. Zur Aktivierung der Reaktion ist es weiterhin auch möglich, eine Lewis-Säure, beispielsweise ein Silbersalz oder AlCl₃, zuzugeben.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, 1,2-, 1,3-, 1,4-Bisphenoxybenzol, Triphenylphosphinoxid, 18-Krone-6, Phenol, 1-Naphthol, Hydrochinon, etc..

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Die erfindungsgemäßen Verbindungen können auch mit einem Polymer gemischt werden. Ebenso ist es möglich, diese Verbindungen kovalent in ein Polymer einzubauen. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. Es ist weiterhin möglich, die Polymere über derartige Gruppen zu vernetzen. Die erfindungsgemäßen Verbindungen und Polymere können als vernetzte oder unvernetzte Schicht eingesetzt werden.

Weiterer Gegenstand der Erfindung sind daher Oligomere, Polymere oder Dendrimere enthaltend eine oder mehrere der oben aufgeführten erfindungsgemäßen Verbindungen, wobei ein oder mehrere Bindungen der erfindungsgemäßen Verbindung zum Polymer, Oligomer oder Dendrimer vorhanden sind. Je nach Verknüpfung der erfindungsgemäßen Verbindung bildet diese daher eine Seitenkette des Oligomers oder Polymers oder ist in der Hauptkette verknüpft. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Verbindungen in Oligomeren, Dendrimeren und Polymeren gelten dieselben Bevorzugungen, wie oben beschrieben.

Zur Herstellung der Oligomere oder Polymere werden die erfindungsgemäßen Monomere homopolymerisiert oder mit weiteren Monomeren copolymerisiert. Bevorzugt sind Copolymere, wobei die Einheiten gemäß Formel (1) bzw. die oben ausgeführten bevorzugten Ausführungsformen zu 0.01 bis 99.9 mol%, bevorzugt 5 bis 90 mol%, besonders bevorzugt 20 bis 80 mol% vorhanden sind. Geeignete und bevorzugte Comonomere, welche das Polymergrundgerüst bilden, sind gewählt aus Fluorenen (z. B. gemäß EP 842208 oder WO 2000/022026), Spirobifluorenen (z. B. gemäß EP 707020, EP 894107 oder WO 2006/061181), Para-phenylenen (z. B. gemäß WO 92/18552), Carbazolen (z. B. gemäß WO 2004/070772 oder WO 2004/113468), Thiophenen (z. B. gemäß EP 1028136), Dihydrophenanthrenen (z. B. gemäß WO 2005/014689), cis- und trans-Indenofluorenen (z. B. gemäß WO 2004/041901oder WO 2004/113412), Ketonen (z. B. gemäß WO 2005/040302), Phenanthrenen (z. B. gemäß WO 2005/104264 oder WO 2007/017066) oder auch mehreren dieser Einheiten. Die Polymere, Oligomere und Dendrimere können noch weitere Einheiten enthalten, beispielsweise Lochtransporteinheiten, insbesondere solche basierend auf Triarylaminen, und/oder Elektronentransporteinheiten.

Für die Verarbeitung der erfindungsgemäßen Verbindungen aus flüssiger Phase, beispielsweise durch Spin-Coating oder durch Druckverfahren, sind Formulierungen der erfindungsgemäßen Verbindungen erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Hexamethylindan, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-lsopropylnaphthalin, Pentylbenzol, Hexylbenzol, Heptylbenzol, Octylbenzol, 1,1-Bis(3,4-dimethylphenyl)ethan oder Mischungen dieser Lösemittel.

Nochmals ein weiterer Gegenstand der vorliegenden Erfindung ist daher eine Formulierung, enthaltend eine erfindungsgemäße Verbindung bzw. ein erfindungsgemäßes Oligomer, Polymer oder Dendrimer und mindestens eine weitere Verbindung. Die weitere Verbindung kann beispielsweise ein Lösemittel sein. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Eine wertvolle Zwischenverbindung zur Herstellung der erfindungsgemäßen Verbindungen sind die entsprechenden freien Liganden. Weiterer Gegenstand der Erfindung ist daher eine Verbindung der folgenden Formel (63), 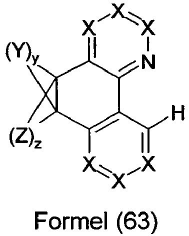 wobei die verwendeten Symbole und Indizes die oben genannten Bedeutungen aufweisen. Dabei gelten die oben für die erfindungsgemäßen Metallkomplexe genannten Bevorzugungen auch entsprechend für den freien Liganden der Formel (63).

Die oben beschriebenen Verbindungen gemäß Formel (1) bzw. die oben aufgeführten bevorzugten Ausführungsformen können in der elektronischen Vorrichtung als aktive Komponente verwendet werden. Ein weiterer Gegenstand der Erfindung ist daher die Verwendung einer Verbindung gemäß Formel (1) bzw. gemäß den bevorzugten Ausführungsformen in einer elektronischen Vorrichtung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoOs oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten. Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Komplexe gemäß Formel (1) als Co-Matrix für längerwellig emittierende Triplettemitter, beispielsweise für grün oder rot emittierende Triplettemitter, eingesetzt werden.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial oder als Elektronenblockiermaterial. Ebenso lassen sich die erfindungsgemäßen Komplexe als Matrixmaterial für andere phosphoreszierende Metallkomplexe in einer emittierenden Schicht einsetzen.

Auch die freien Liganden der Formel (63) können direkt in elektronischen Vorrichtungen, insbesondere in organischen Elektrolumineszenzvorrichtungen eingesetzt werden, je nach genauer Struktur und Substitution in verschiedenen Funktionen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, AI, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoOs oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden: Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Organische Elektrolumineszenzvorrichtungen enthaltend die erfindungsgemäßen Verbindungen als emittierende Materialien weisen eine sehr gute Lebensdauer auf. Insbesondere ist die Lebensdauer verbessert gegenüber analogen Verbindungen gemäß dem Stand der Technik, die statt einer Gruppe der Formel (3) eine entsprechende aliphatische Brücke aufweisen, die keine bicyclische bzw. polycyclische Struktur aufweist.
2. Die erfindungsgemäßen Metallkomplexe weisen eine sehr gute thermische Stabilität auf.
3. Die erfindungsgemäßen Metallkomplexe sind hervorragend in einer Vielzahl organischer Lösemittel löslich, insbesondere in organischen Kohlenwasserstoffen. Dabei ist die Löslichkeit gegenüber analogen Verbindungen, die keine Struktureinheit der Formel (3) enthalten, deutlich verbessert. Dies führt zu einer vereinfachten Aufreinigung während der Synthese der Komplexe sowie zu deren hervorragender Eignung bei der Herstellung von OLEDs in lösungsprozessierten Verfahren, beispielsweise Druckverfahren.
4. Dier erfindungsgemäßen Metallkomplexe weisen eine sehr hohe Oxidationsstabilität an Luft und Licht auf, so dass deren Verarbeitung aus Lösung, beispielsweise durch Druckverfahren, auch an der Luft möglich ist.
5. Die erfindungsgemäßen Metallkomplexe weisen im Vergleich zu analogen Verbindungen, welche keine Struktureinheit gemäß Formel (3) enthalten, eine reduzierte Aggregation auf. Dies äußert sich in einer niedrigeren Sublimationstemperatur im Vergleich zu analogen Komplexen, die keine Struktureinheit gemäß Formel (3) enthalten.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Synthese der Synthone S und Liganden L:

### Beispiel S1 und L1:

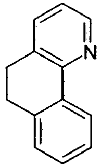

Analog G. Abbiati et al., J. Org. Chem., 2003, 68, 18, 6959. 73.1 g (500 mmol) 1-Tetralon [529-34-0], 44.1 g (800 mmol) Propargylamin [2450-71-7] und 2.9 g (10 mmol) Natriumdichloroaurat(l) [21534-24-7] in 1000 ml abs. Ethanol werden 12 h bei 130 °C im Autoklaven gerührt. Nach Erkalten wird das EtOH im Vakuum entfernt, der Rückstand wird in 300 ml Dichlormethan aufgenommen und über ein Kieselgelbett filtriert. Nach Einengen des Filtrats wird der Rückstand im Vakuum (p ca. 0.05 mbar, T ca. 185 °C) destilliert. Ausbeute: 58.9 g (325 mmol), 65 %; Reinheit: ca. 98%ig nach ¹H-NMR.

Analog können folgende Verbindungen dargestellt werden, wobei die Reinigung der Rohprodukte durch Destillation, Kugelrohdestillation, Umkristallisation oder Chromatographie erfolgen kann:

| Bsp. | Edukt | Produkt | Ausbeute |
|---|---|---|---|
| L2 | 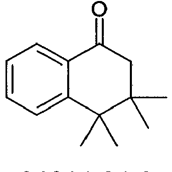 | 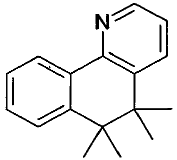 | 28 % |
| | 91814-04-0 | | |
| S2 | 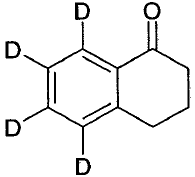 | 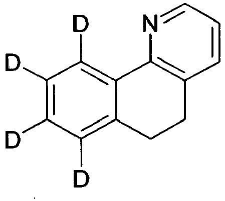 | 63 % |
| | 86419-92-3 | | |
| S3 | 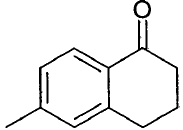 | 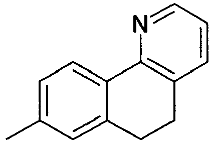 | 58 % |
| | 51015-29-3 | | |
| S4 | 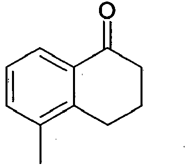 | 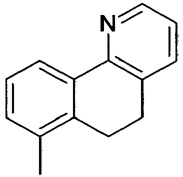 | 60 % |
| | 6939-35-1 | | |
| S5 | 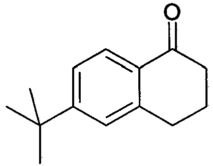 | 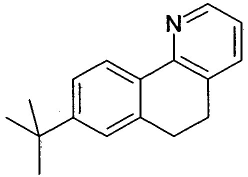 | 71 % |
| | 51015-37-3 | | |
| S6 | 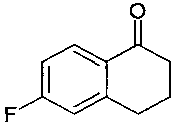 | 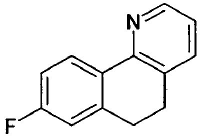 | 66 % |
| | 703-67-3 | | |
| S7 | 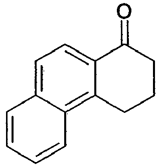 | 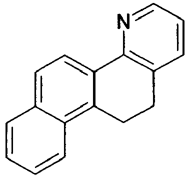 | 78 % |
| | 573-22-8 | | |
| S8 | 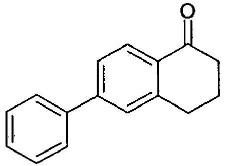 | 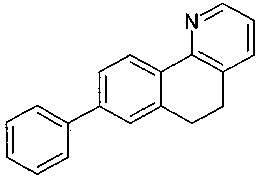 | 56 % |
| | 71912-46-4 | | |
| S9 | 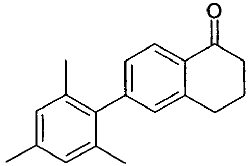 1 | 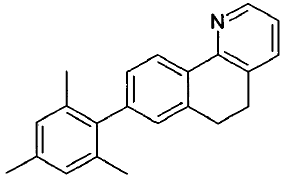 | 63 % |
| | 27255-71-4 | | |
| S10 | 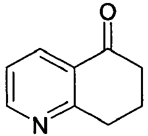 | 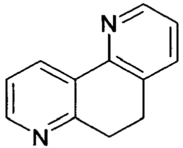 | 70% |
| | 53400-41-2 | | |
| S11 | 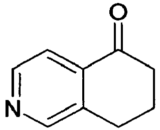 | 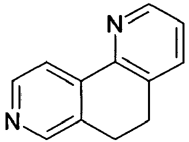 | 73 % |
| | 21917-86-2 | | |
| S12 | 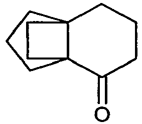 | 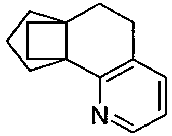 | 53 % |
| | 38229-67-3 | | |
| S13 | 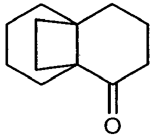 | 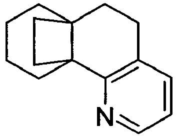 | 55 % |
| | 38312-61-7 | | |
| L3 | 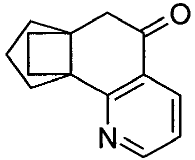 | 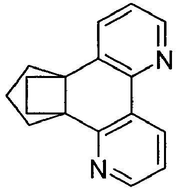 | 31 % |
| | S14 | | |
| L4 | 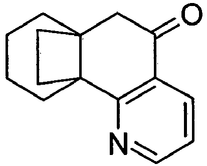 | 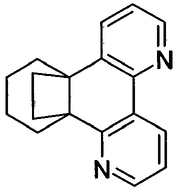 | 27 % |
| | S15 | | |

### Beispiel S14:

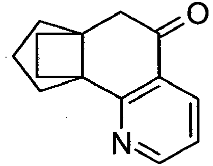

Analog L. Ren et al., Green Chemistry, 2015, 17, 2369.

Ein Gemisch aus 2.0 g (10 mmol) S12, 6.9 g (50 mmol) tert-Butylhydroperoxid [75-91-2] (65 Gew.-% in Wasser) und 50 ml tert-Butanol wird bei 25 °C mit 35 mg (0.1 mmol) Mangan(II)trifluormethansulfonat [55120-76-8] versetzt und 30 h gerührt. Man entfernt 45 ml des Lösungsmittels im Vakuum, versetzt den Rückstand mit 200 ml Wasser und extrahiert dreimal mit je 200 ml Dichlormethan. Die vereinigten Extrakte werden fünfmal mit je 200 ml Wasser und zweimal mit je 100 ml gesättigter Kochsalzlösung gewaschen und über Magnesiumsulfat getrocknet. Das nach Entfernen des Lösungsmittels verbleibende Öl wird ohne weitere Reinigung eingesetzt. Ausbeute: 1.7 g (7.9 mmol), 79 %; Reinheit: ca. 95%ig nach ¹H-NMR.

Analog kann S15 aus S13 dargestellt werden. Ausbeute 76 %.

### Beispiel S16:

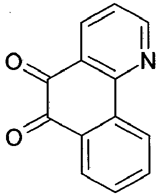

Eine Mischung aus 45.3 g (250 mmol) S1, 250 ml Eisessig und 250 ml Acetanhydrid wird unter gutem Rühren portionsweise mit 10 Portionen zu je 11.2 g (375 mmol) Natriumdichromat-Dihydrat alle 30 min. versetzt und dann 1 Tag bei Raumtemperatur und 3 Tage bei 35 °C gerührt. Dann rührt man die gelbe Suspansion vorsichtig (exotherm!) in 5 kg Eis ein, rührt 30 min. nach, saugt vom gelben Feststoff ab, wäscht diesen fünfmal mit je 300 ml Wasser und saugt trocken. Das Rohprodukt wird in 500 ml Dichlormethan gelöst und über ein Kieselgelbett filtriert. Man entfernt das Dichlormethan im Vakuum und rührt den Feststoff einmal mit 200 ml Methanol heiß aus. Ausbeute: 29.9 g (143 mmol), 57%; Reinheit: ca. 99%ig nach ¹H-NMR.

Analog können folgende Verbindungen dargestellt werden:

| Bsp. | Edukt | Produkt | Ausbeute |
|---|---|---|---|
| S17 | 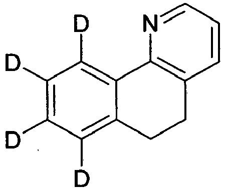 | 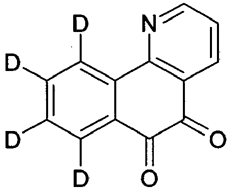 | 63 % |
| | S2 | | |
| S18 | 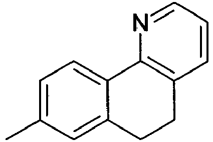 | 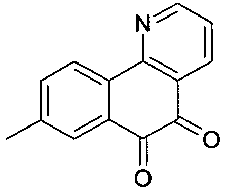 | 18 % |
| | S3 | | |
| S19 | 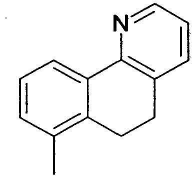 | 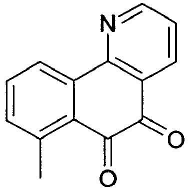 | 21 % |
| | S4 | | |
| S20 | 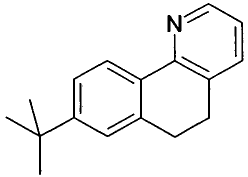 | 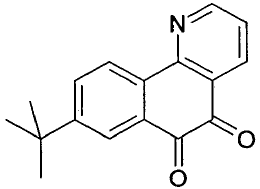 | 64 % |
| | S5 | | |
| S21 | 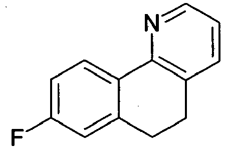 | 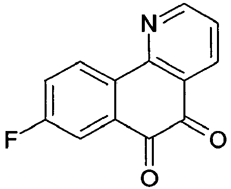 | 60 % |
| | S6 | | |
| S22 | 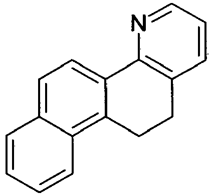 | 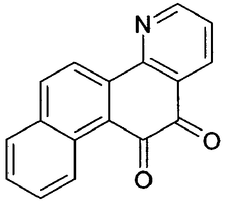 | 78% |
| | S7 | | |
| S23 | 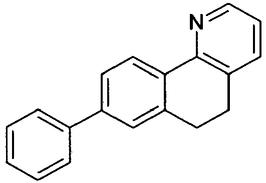 | 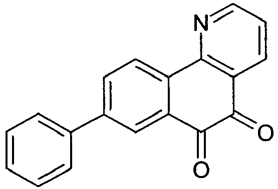 | 71 % |
| | S8 | | |
| S24 | 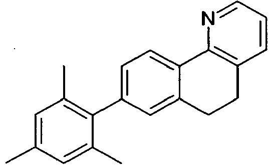 | 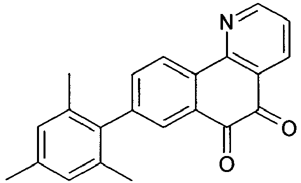 | 34 % |
| | S9 | | |
| S25 | 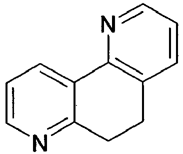 | 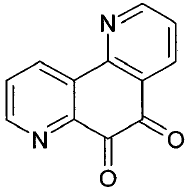 | 48 % |
| | S10 | | |
| S26 | 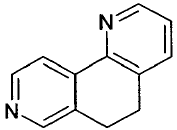 | 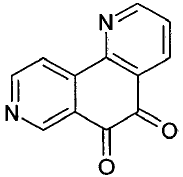 | 55 % |
| | S11 | | |

### Beispiel S27:

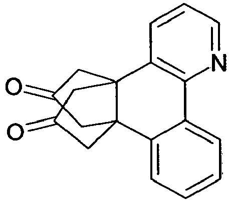

Man bereitet aus 23.0 g (1 mol) Natrium und 2000 ml Methanol eine Natriummethanolat-Lösung. Zu dieser gibt man unter Rühren 87.1 g (500 mmol) 1,3-Acetondicarbonsäuredimethylester [1830-54-2] und rührt 10 min. nach. Dann fügt man 41.8 g (200 mmol) S16 fest zu. Nach 16 h rühren unter Rückfluss entfernt man das Methanol im Vakuum. Man versetzt den Rückstand vorsichtig mit 1000 ml Eisessig (Achtung: Schäumen!) und fügt zur braunen Lösung 60 ml Wasser und 180 ml konz. Salzsäure zu. Man erhitzt die Reaktionsmischung 16 h unter Rückfluss, lässt dann erkalten, gießt auf 5 kg Eis und neutralisiert unter Kühlung durch Zugabe von fester Natronlauge. Man saugt vom ausgefallenen Feststoff ab, wäscht diesen dreimal mit je 300 ml Wasser nach und trocknet im Vakuum. Das Rohprodukt wird 1 h in 2000 ml Dichlormethan bei 40 °C gerührt und dann noch warm über ein Celite-Bett filtriert, um unlösliche Anteile zu entfernen. Nach Entfernen des Dichlormethans im Vakuum wird der Rückstand in 100 ml Dioxan in der Siedehitze gelöst und dann ab 80 °C tropfenweise mit 500 ml Methanol versetzt. Nach Erkalten und 12 h Nachrühren bei Raumtemperatur wird der Feststoff abgesaugt, mit etwas Methanol gewaschen und im Vakuum getrocknet. Ausbeute: 29.5 g (102 mmol), 51%; Reinheit: ca. 90%ig nach ¹H-NMR. Das so erhaltene Produkt wird ohne Reinigung weiter umgesetzt.

Analog können folgende Verbindungen dargestellt werden:

| Bsp. | Edukt | Produkt | Ausbeute |
|---|---|---|---|
| S28 | 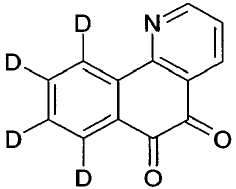 | 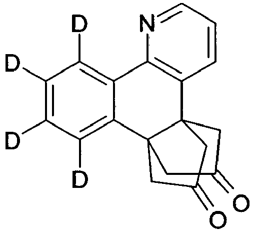 | 50 % |
| | S17 | | |
| S29 | 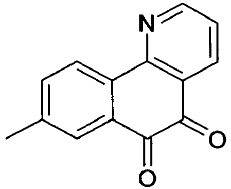 | 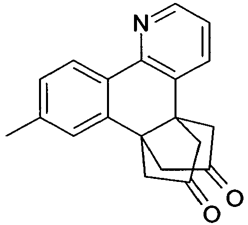 | 53 % |
| | S18 | | |
| S30 | 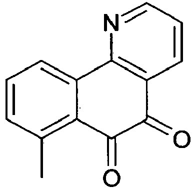 | 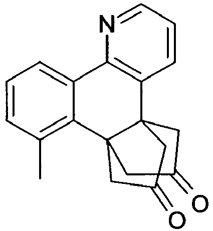 | 48 % |
| | S19 | | |
| S31 | 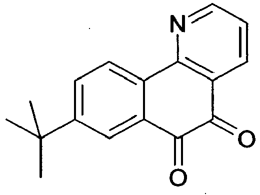 | 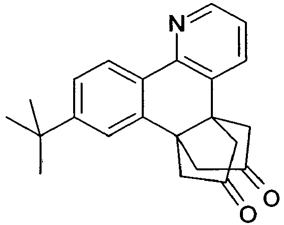 | 57 % |
| | S20 | | |
| S32 | 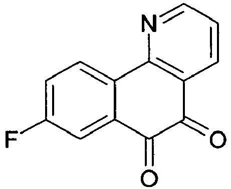 | 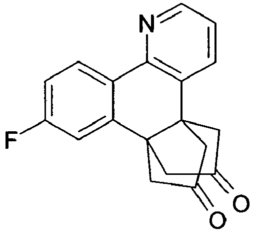 | 55 % |
| | S21 | | |
| S33 | 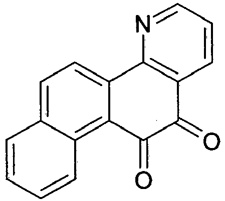 | 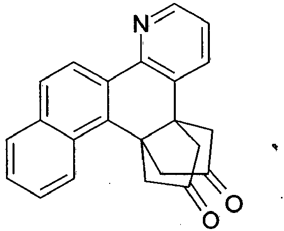 | 21 % |
| | S22 | | |
| S34 | 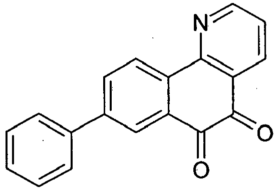 | 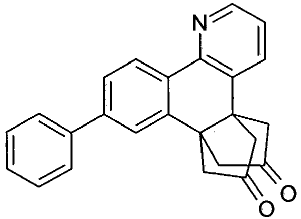 | 59 % |
| | S23 | | |
| S35 | 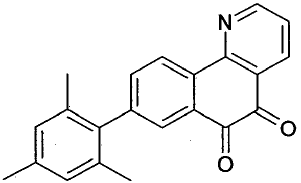 | 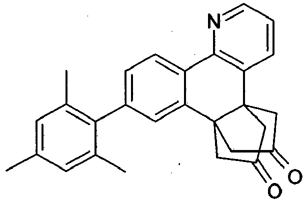 | 54 % |
| | S24 | | |
| S36 | 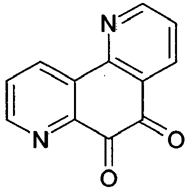 | 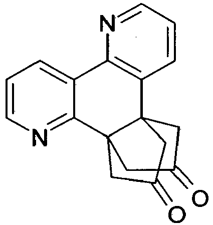 | 63 % |
| | S25 | | |
| S37 | 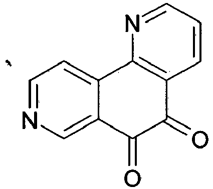 | 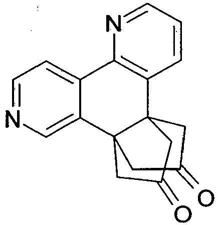 | 60 % |
| | S26 | | |
| S38 | 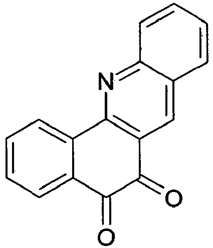 | 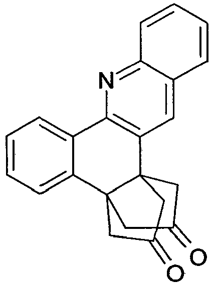 | 55 % |
| | 60692-59-3 | | |
| S39 | 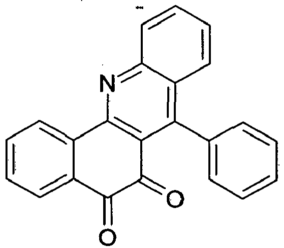 | 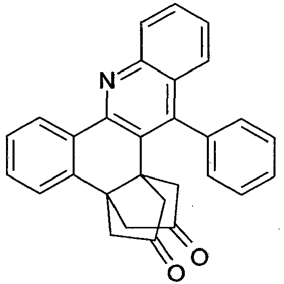 | 11 % |
| | 1620974-86-8 | | |

### Beispiel L5:

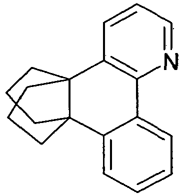

Ein Gemisch aus 28.9 g (100 mmol) S27, 50.1 g (1 mol) Hydrazinhydrat, 67.3 g (1.2 mol) Kaliumhydroxid und 400 ml Ethylenglykol wird 4 h unter Rückfluss erhitzt. Dann steigert man die Temperatur langsam und destilliert das gebildete Wasser und überschüssiges Hydrazinhydrat am Wasserabscheider ab. Nach 16 h unter Rückfluss lässt man die Reaktionsmischung erkalten, gießt in 2 l Wasser ein und extrahiert dreimal mit je 500 ml Dichlormethan. Man wäscht die Dichlormethanphase fünfmal mit je 300 ml Wasser, und zweimal mit je 300 ml gesättigter Kochsalzlösung und trocknet über Magnesiumsulfat. Nach Entfernen das Dichlormethans im Vakuum wird der ölige Rückstand an Kieselgel mit Dichlormethan chromatographiert (Rf ca. 0.6). Zur weiteren Reiningung kann das so erhaltene hellgelbe Öl Kugelrohr-destilliert oder aus Methanol umkristallisiert werden. Ausbeute: 12.0 g (46 mmol), 46 %; Reinheit: ca. 99%ig nach ¹H-NMR.

Analog können folgende Verbindungen dargestellt werden:

| Bsp. | Edukt | Produkt | Ausbeute |
|---|---|---|---|
| L6 | 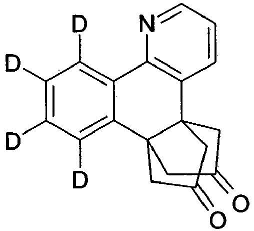 | 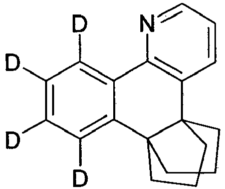 | 51 % |
| | S28 | | |
| L7 | 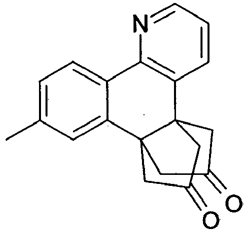 | 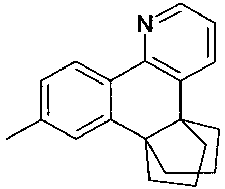 | 48 % |
| | S29 | | |
| L8 | 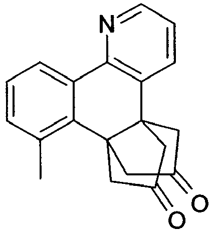 | 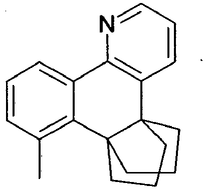 | 43 % |
| | S30 | | |
| L9 | 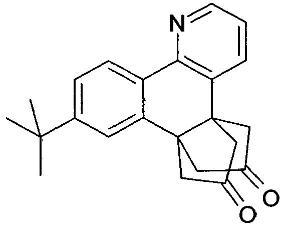 | 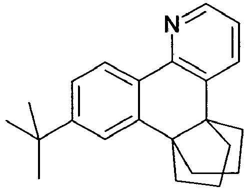 | 55 % |
| | S31 | | |
| L10 | 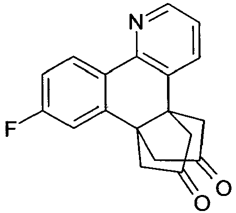 | 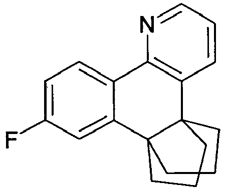 | 21 % |
| | S32 | | |
| L11 | 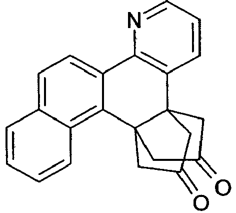 | 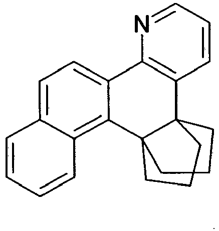 | 62 % |
| | S33 | | |
| L12 | 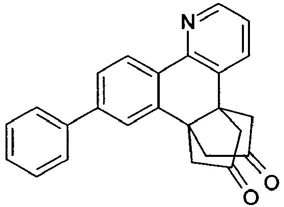 | 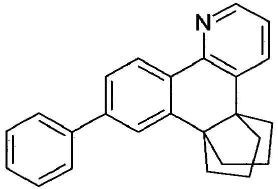 | 58 % |
| | S34 | | |
| L13 | 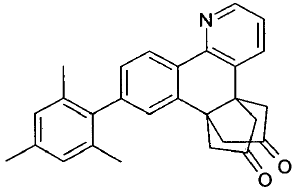 | 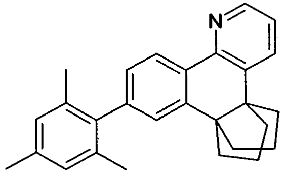 | 61 % |
| | S35 | | |
| L14 | 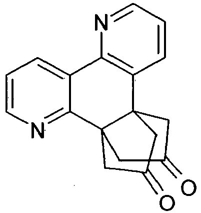 | 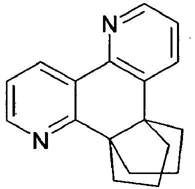 | 59 % |
| | S36 | | |
| L15 | 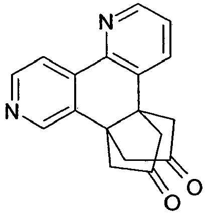 | 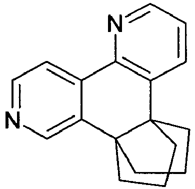 | 50 % |
| | S37 | | |
| L16 | 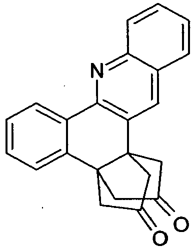 | 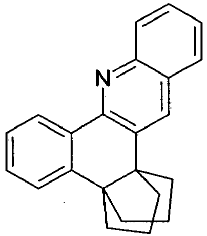 | 63 % |
| | S38 | | |
| L17 | 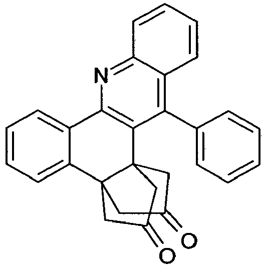 | 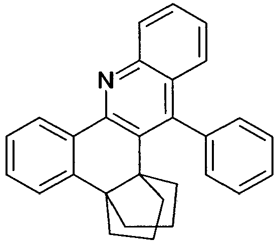 | 31 % |
| | S39 | | |

### C: Synthese der Metallkomplexe:

### 1) Tris-faciale homoleptische Ir-Komplexe

### Beispiel Ir(L5)₃:

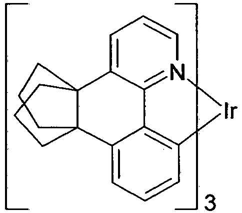

### Variante A:

Ein Gemisch aus 9.2 g (35 mmol) des Liganden L5, 4.90 g (10 mmol) Tris-acetylacetonato-iridium(III) [15635-87-7] und 100 g Hydrochinon [123-31-9] wird in einem 500 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 260 °C, gemessen am Pt-100 Thermofühler, der in die aufgeschmolzene, gerührte Reaktionsmischung eintaucht, erhitzt. Während der nächsten 1.5 h wird das Reaktionsgemisch bei 260 °C gehalten, wobei wenig Kondensat abdestilliert und sich im Wasserabscheider sammelt. Nach Abkühlen auf 100 °C wird der Schmelzkuchen vorsichtig mit 500 mL Methanol versetzt und ausgekocht, bis eine gelbe Suspension entstanden ist. Die so erhaltene gelbe Suspension wird über eine Umkehrfritte (P3) filtriert, der gelbe Feststoff wird dreimal mit 100 ml Methanol gewaschen und dann im Vakuum getrocknet. Rohausbeute: quantitativ. Die weitere Reinigung des gelben Produkts erfolgt durch fünfmalige kontinuierliche Heißextraktion mit Toluol (Vorlagemenge jeweils ca. 150 ml, Extraktionshülse: Standard Soxhletthülsen aus Cellulose der Fa. Whatman) unter sorgfältigem Luft- und Lichtausschluss. Abschließend wird das Produkt im Hochvakuum (p ca. 10⁻⁵ mbar, T 340°C) fraktioniert sublimiert. Ausbeute: 7.6 g (7.8 mmol), 78 %. Reinheit: > 99.9 % nach HPLC.

### Variante B:

Durchführung analog Beispiel Ir(L5)₃, Variante A jedoch werden statt 100 g Hydrochinon 300 mL Ethylenglykol [107-21-1] verwendet, und es wird 48 h unter Rückfluss gerührt. Nach Erkalten auf 70 °C wird mit 300 mL Ethanol verdünnt, der Feststoff wird abgesaugt (P3), dreimal mit je 100 mL Ethanol gewaschen und im Vakuum getrocknet. Die weitere Reinigung erfolgt wie unter Variante A beschrieben. Ausbeute: 4.4 g (4.5 mmol), 45 %. Reinheit: > 99.9 % nach HPLC.

### Variante C:

### Natrium[cis-,trans-di-chloro-(bis-acetylacetonato)]iridat(III) als Iridium-Edukt

Ein Gemisch aus 10 mmol Natrium[cis-,trans-di-chloro-(bis-acetyl-acetonato)]iridat(III) [876296-21-8] und 40 mmol des Liganden in 100 ml Ethylenglykol (alternativ auch Propylen- oder Diethylenglykol) wird unter einem leichten Argonstrom für die angegebene Zeit unter schwachem Rückfluss erhitzt. Nach Erkalten auf 60 °C verdünnt man unter Rühren mit einem Gemisch aus 50 ml Ethanol und 50 ml 2 N Salzsäure, rührt 1 h nach, saugt vom ausgefallenen Feststoff ab, wäscht diesen dreimal mit je 30 ml Ethanol und trocknet dann im Vakuum. Reinigung wie unter A beschrieben. Ausbeute: 5.9 g (6.1 mmol), 61 %. Reinheit: > 99.9 % nach HPLC.

Die Reinigung der nach Variante A, B und C erhaltenen Komplexe kann neben der Reinigung durch wiederholte Heißextraktion auch durch Umkristallsation oder durch Chromatographie erfolgen.

Werden chirale Liganden eingesetzt, fallen die abgeleiteten fac-Metallkomplexe als Diastereomerenmischung an. Die Enantiomere Λ,Δ der Punktgruppe C3 weisen in der Regel eine deutlich geringere Löslichkeit im Extraktionsmittel auf als die Enatiomeren der Punktgruppe C1, die sich folglich in der Mutterlauge anreichern. Eine Trennung der C3- von den C1-Diasteromeren auf diesem Wege ist häufig möglich. Daneben können die Diastereomeren auch chromatographisch getrennt werden. Werden Liganden der Punktgruppe C1 enantiomerenrein eingesetzt, entsteht ein Diasteromerenpaar Λ,Δ der Punktgruppe C3. Die Diastereomeren können durch Kristallisation oder Chromatographie getrennt und damit als enantiomerenreine Verbindungen erhalten werden.

Analog können folgende Verbindungen dargestellt werden:

| Produkt | Ligand | Variante Reaktionszeit* Reaktionstemperatur* Extraktionsmittel* | Ausbeute |
|---|---|---|---|
| Ir(L1)₃ (Vgl.) | L1 | 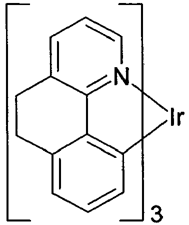 | 42 % |
| | | A | |
| Ir(L2)₃ (Vgl.) | L2 | A | 26 % |
| | | 2 h | |
| | | Ethylacetat | |
| Ir(L3)₃ | L3 | 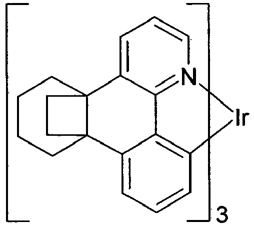 | 56 % |
| | | A Diastereomerengemisch | |
| Ir(L4)₃ | L4 | A Diastereomerengemisch | 58 % |
| Ir(L6)₃ | L6 | A | 76 % |
| | | 3 h | |
| Ir(L7)₃ | L7 | A | 78 % |
| Ir(L8)₃ | L8 | A | 75 % |
| Ir(L9)₃ | L9 | A | 81 % |
| | | C, 60 h | 69 % |
| Ir(10)₃ | L10 | A | 58 % |
| | | B | 46 % |
| Ir(11)₃ | L11 | A | 80 % |
| | | 2 h | |
| | | Mesitylen | |
| Ir(L12)₃ | L12 | A | 76 % |
| Ir(L13)₃ | L13 | A | 81 % |
| Ir(L14)₃ | L14 | 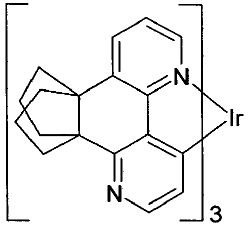 | 66 % |
| | | A | |
| | | 3 h | |
| | | 270 °C | |
| Ir(L15)₃ | L15 | A | 63 % |
| | | 3 h | |
| | | 270 °C | |

| | | | |
|---|---|---|---|
| * Sofern abweichend von den beschriebenen Bedingungen | | | |

### 2) Iridium-Komplexe vom Typ [Ir(L)₂Cl]₂

### Variante A:

Ein Gemisch aus 22 mmol des Liganden, 10 mmol Iridium(III)chlorid-Hydrat [876296-21-8], 75 ml 2-Ethoxyethanol und 25 ml Wasser wird unter gutem Rühren 16-24 h unter Rückfluss erhitzt. Falls sich der Ligand nicht oder nicht vollständig im Lösungsmittelgemisch unter Rückfluss löst, wird so lange 1,4-Dioxan zugesetzt, bis eine Lösung entstanden ist. Nach Erkalten saugt man vom ausgefallenen Feststoff ab, wäscht diesen zweimal mit Ethanol/ Wasser (1:1, vv) und trocknet dann im Vakuum. Das so erhaltene Chloro-Dimer der Formel [Ir(L)₂Cl]₂ wird ohne Reinigung weiter umgesetzt.

### Variante B:

Ein Gemisch aus 10 mmol Natrium-bis-acetylacetonato-dichloro-iridat(III) [876296-21-8], 22 mmol des Liganden L und ein glasummantelter Magnetrührkern werden unter Vakuum (10⁻⁵ mbar) in eine dickwandige 100 ml Glasampulle abgeschmolzen. Als Schmelzhilfe und Reaktionsmedium kann Hydrochinon zugesetzt werden. Die Ampulle wird für die angegebene Zeit bei der angegebenen Temperatur getempert, wobei das aufgeschmolzene Gemisch mit Hilfe eines Magnetrührers gerührt wird. Nach Erkalten (ACHTUNG: die Ampullen stehen meist unter Druck!) wird die Ampulle geöffnet, der Sinterkuchen wird mit 100 g Glaskugeln (3 mm Durchmesser) in 100 ml des angegebenen Suspensionsmittels (das Suspensionsmittel wird so gewählt, dass der Ligand gut, das Chloro-Dimer der Formel [Ir(L)₂Cl]₂ jedoch schlecht darin löslich ist; typische Suspensionsmittel sind Methanol, Ethanol, Dichlormethan, Aceton, Ethylacetat, Toluol, etc.) 3 h gerührt und dabei mechanisch aufgeschlossen. Man dekantiert die feine Suspension von den Glaskugeln ab, saugt den Feststoff [Ir(L)₂Cl]₂, der noch ca. 2 eq. NaCl enthält, nachfolgend das rohe Chloro-Dimer genannt, ab und trocknet diesen im Vakuum. Das so erhaltene rohe Chloro-Dimer der Formel [Ir(L)₂Cl]₂ wird ohne Reinigung weiter umgesetzt.

| **Bsp.** | **Ligand L** | **Ir-Komplex Variante Temp. / Zeit Schmelzhilfe Suspensionsmittel** | **Ausbeute** |
|---|---|---|---|
| [Ir(L5)₂Cl]₂ | L5 | 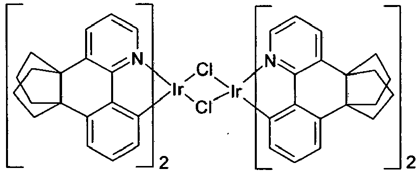 | 76% |
| | | A | |
| [Ir(L5)₂Cl]₂ | L5 | [Ir(L5)₂Cl]₂ | 81 % |
| | | B | |
| | | 230°C / 12 h | |
| | | Hydrochinon | |
| [Ir(L7)₂Cl]₂ | L7 | [Ir(L7)₂Cl]₂ | 84 % |
| | | B | |
| | | 230°C / 12 h | |
| [Ir(L9)₂Cl]₂ | L9 | [Ir(L9)₂Cl]₂ | 93 % |
| | | B | |
| | | 230°C / 12 h | |
| [Ir(L12)₂Cl]₂ | L12 | [Ir(L12)₂Cl]₂ | 90 % |
| | | B | |
| | | 230°C / 12 h | |
| | | Hydrochinon | |
| [Ir(L14)₂Cl]₂ | L14 | [Ir(L14)₂Cl]₂ | 76 % |
| | | B | |
| | | 240°C / 12 h | |
| [Ir(L16)₂Cl]₂ | L16 | [Ir(L16)₂Cl]₂ | 92 % |
| | | B | |
| | | 230°C / 12 h | |
| [Ir(L17)₂Cl]₂ | L17 | [Ir(L17)₂Cl]₂ | 89 % |
| | | B | |
| | | 230°C / 12 h | |

### 3) Iridium-Komplexe vom Typ [Ir(L)₂(HOMe)₂]OTf

Eine Suspension von 5 mmol des Chloro-Dimers [Ir(L)₂Cl]₂ in 150 ml Dichlormethan wird mit 5 ml Methanol und dann mit 10 mmol Silber(I)trifluormethansulfonat [2923-28-6] versetzt und 18 h bei Raumtemperatur gerührt. Man saugt vom ausgefallenen Silber(I)chlorid über ein Celite-Bett ab, engt das Filtrat zur Trockene ein, nimmt den gelben Rückstand in 30 ml Toluol oder Cyclohexan auf, filtriert vom Feststoff ab, wäscht diesen mit n-Heptan und trocknet im Vakuum. Das so erhaltene Produkt der Formel [Ir(L)₂(HOMe)₂]OTf wird ohne Reinigung weiter umgesetzt.

| **Bsp.** | **[Ir(L)₂Cl]₂** | **[Ir(L)₂(HOMe)₂]OTf** | **Ausbeute** |
|---|---|---|---|
| [Ir(L5)₂(HOMe)₂]OTf | Ir[(L5)Cl]₂ | 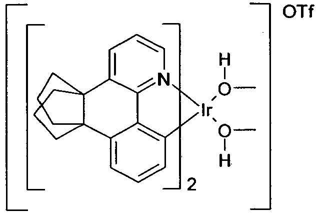 | 81% |
| [Ir(L7)₂(HOMe)₂]OTf | [Ir(L7)₂Cl]₂ | [Ir(L7)₂(HOMe)₂]OTf | 85 % |
| [Ir(L9)₂(HOMe)₂]OTf | [Ir(L9)₂Cl]₂ | [Ir(L9)₂(HOMe)₂]OTf | 79 % |
| [Ir(L12)₂(HOMe)₂]OTf | [Ir(L12)₂Cl]₂ | [Ir(L12)₂(HOMe)₂]OTf | 74 % |
| [Ir(L14)₂(HOMe)₂]OTf | [Ir(L14)₂Cl]₂ | [Ir(L14)₂(HOMe)₂]OTf | 83 % |
| [Ir(L16)₂(HOMe)₂]OTf | [Ir(L16)₂Cl]₂ | [Ir(L16)₂(HOMe)₂]OTf | 91 % |
| [Ir(L17)₂(HOMe)₂]OTf | [Ir(L17)₂Cl]₂ | [Ir(L17)₂(HOMe)₂]OTf | 88 % |

### 4) Heteroleptische tris-faciale Iridium-Komplexe :

Ein Gemisch aus 10 mmol des Liganden L bzw. L', 10 mmol Bis-(methanol)bis[2-(2-pyridinyl-κN]phenyl-κC]iridium(III)-trifluormethansulfonat [1215692-14-0] bzw. erfindungsgemäße Iridium-Komplexe vom Typ [Ir(L)₂(HOMe)₂]OTf, 11 mmol 2,6-Dimethylpryridin und 150 ml Ethanol wird 40 h unter Rückfluss erhitzt. Nach Erkalten saugt man vom ausgefallenen Feststoff ab, wäscht diesen dreimal mit je 30 ml Ethanol und trocknet im Vakuum. Das so erhaltene Rohprodukt wird an Kieselgel (Lösemittel bzw. deren Gemische, z.B. Ethylacetat, DCM, THF, Toluol, n-Heptan, Cyclohexan) chromatographiert, und wie unter 1) Variante A beschrieben fraktioniert sublimiert.

| **Bsp.** | **[Ir(L)₂(HOMe)₂]OTf Ligand L** | **Ir-Komplex Diastereomer** | **Ausbeute** |
|---|---|---|---|
| Ir200 (Vgl.) | 1215692-14-0 L1 | 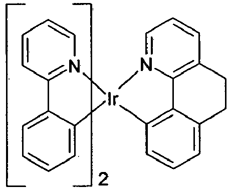 | 27 % |
| Ir201 | 1215692-14-0 L3 | 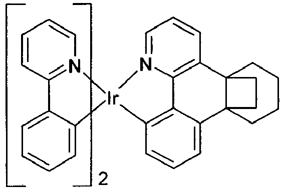 | 39 % |
| | | Diastereomerengemisch Trennung mittels Chromatigraphie DCM / Kieselgel | |
| Ir202 | 1215692-14-0 L5 | 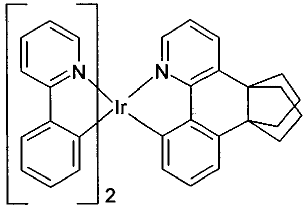 | 44 % |
| Ir203 | [Ir(L5)₂(HOMe)₂]OTf 1008-89-5 | 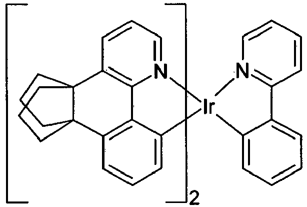 | 48 % |
| Ir204 | [Ir(L5)₂(HOMe)₂]OTf 26274-35-1 | 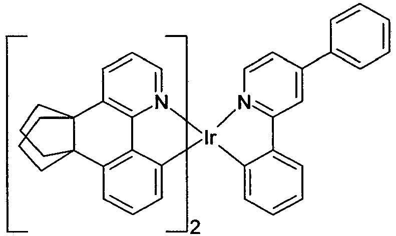 | 45 % |
| Ir205 | [Ir(L5)₂(HOMe)₂]OTf 156021-09-8 | 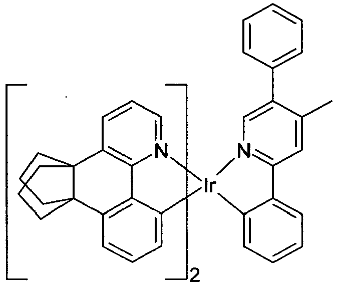 | 50 % |
| Ir206 | [Ir(L5)₂(HOMe)₂]OTf 1609373-99-0 | 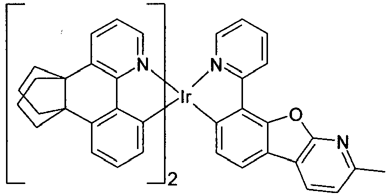 | 54 % |
| Ir207 | [Ir(L5)₂(HOMe)₂]OTf 1609374-17-5 | 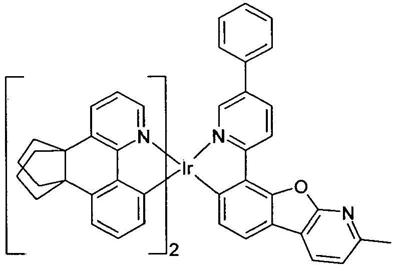 | 51 % |
| Ir208 | [Ir(L12)₂(HOMe)₂]OTf 1609374-06-2 | 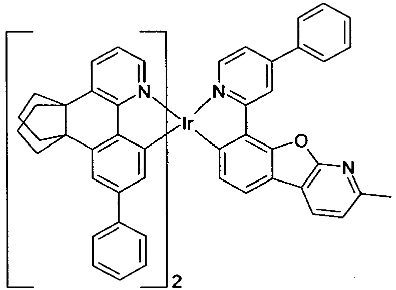 | 46 % |
| Ir209 | [Ir(L14)₂(HOMe)₂]OTf 1609374-23-3 | 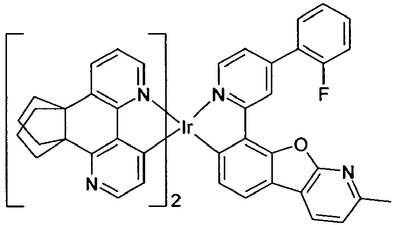 | 48 % |
| Ir210 | [Ir(L5)₂(HOMe)₂]OTf L7 | 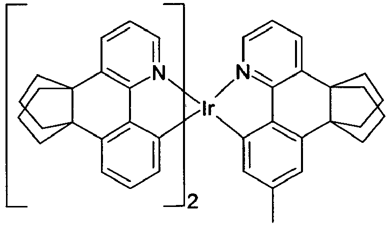 | 50 % |
| Ir211 | [Ir(L5)₂(HOMe)₂]OTf L9 | 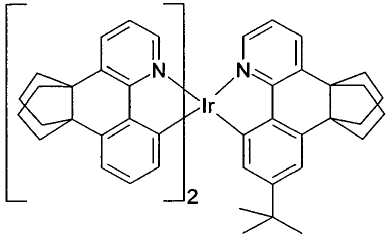 | 50 % |
| Ir212 | [Ir(L5)₂(HOMe)₂]OTf L11 | 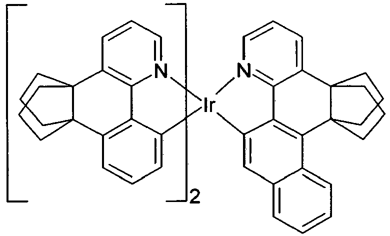 | 44 % |
| Ir213 | [Ir(L5)₂(HOMe)₂]OTf L12 | 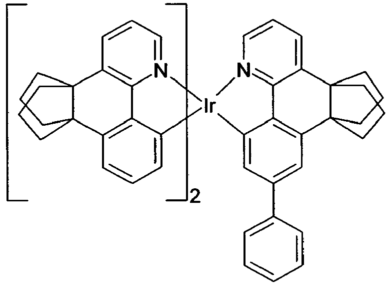 | 47 % |
| Ir214 | [Ir(L5)₂(HOMe)₂]OTf L14 | 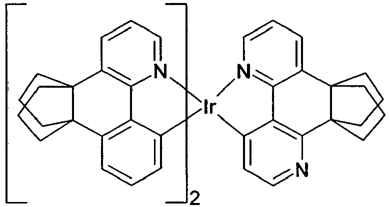 | 34 % |
| Ir215 | [Ir(L14)₂(HOMe)₂]OTf L5 | 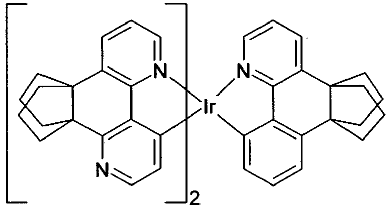 | 52 % |
| Ir216 | [Ir(L14₂(HOMe)₂]OTf L13 | 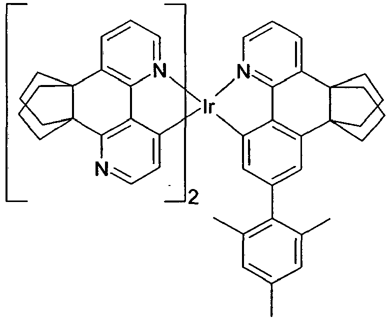 | 49 % |
| Ir217 | [Ir(L5)₂(HOMe)₂]OTf 230-27-3 | 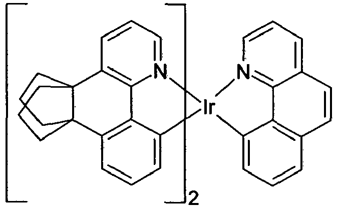 | 31 % |
| Ir218 | [Ir(L14)₂(HOMe)₂]OTf 1541107-37-2 | 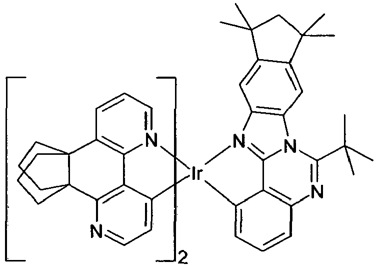 | 39 % |
| Ir219 | [Ir(L14)₂(HOMe)₂]OTf 914306-48-2 | 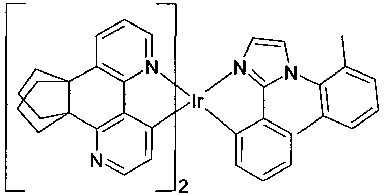 | 40 % |

### 5) Heteroleptische Iridium-Komplexe enthaltend Liganden vom Arduengo-Carben-Typ:

Darstellung analog A. G. Tennyson et al., Inorg. Chem., 2009, 48, 6924. Ein Gemisch aus 22 mmol der Ligandenvorstufe (Imidazoliumsalz),
10 mmol Iridium-Chloro-Dimer [Ir(L)₂Cl]₂, 10 mmol Silber(I)oxid und 300 ml 1,2-Dichlorethan wird 30 h bei 90 °C gerührt. Nach Erkalten saugt man vom ausgefallenen Feststoff über ein Celite-Bett ab, wäscht diesen einmal mit 30 ml 1,2-Dichlorethan und engt das Filtrat im Vakuum zur Trockene ein. Das so erhaltene Rohprodukt wird an Kieselgel (Lösemittel bzw. deren Gemische, z. B. Ethylacetat, Dichlormethan, THF, Toluol, n-Heptan, Cyclohexan) chromatographiert, und wie unter 1) Variante A beschrieben fraktioniert sublimiert.

| **Bsp.** | **[Ir(L)₂Cl]₂ Ligand L** | **Ir-Komplex** | **Ausbeute** |
|---|---|---|---|
| Ir300 | [Ir(L14)₂(HOMe)₂]OTf 1610514-63-0 | 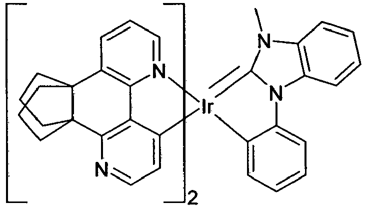 | 35 % |

### 6) Iridium-Komplexe vom Typ Ir(L)₂L' enthaltend nicht o-metallierte Liganden L'

Ein Gemisch aus 25 mmol des Liganden L', 10 mmol Iridium-Chloro-Dimer [Ir(L)₂Cl]₂, 30 mmol Natriumhydrogencarbonat, 100 ml 2-Ethoxyethanol und 30 ml Wasser wird 16 h bei 90 °C gerührt. Nach Erkalten saugt man vom ausgefallenen Feststoff ab, wäscht diesen dreimal mit je 30 ml Ethanol und trocknet im Vakuum. Das so erhaltene Rohprodukt wird an Kieselgel (Lösemittel bzw. deren Gemische, z. B. Ethylacetat, Dichlormethan, THF, Toluol, n-Heptan, Cyclohexan) chromatographiert bzw. umkristallisiert, und wie unter 1) Variante A beschrieben fraktioniert sublimiert.

| **Bsp.** | **[Ir(L)₂Cl]₂ Ligand L'** | **Ir-Komplex Diastereomer** | **Ausbeute** |
|---|---|---|---|
| Ir400 | [Ir(L5)₂Cl]₂ 123-54-6 | 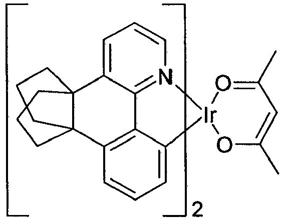 | 79 % |
| | | N,N,-trans, C₂ | |
| Ir401 | [Ir(L9)₂Cl]₂ 1118-71-4 | 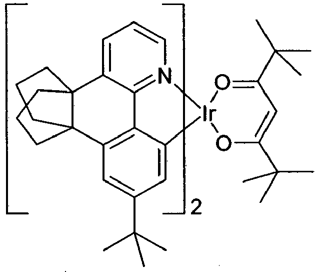 | 71 % |
| | | N,N,-trans, C₂ | |
| Ir402 | [Ir(L16)₂Cl]₂ 123-54-6 | 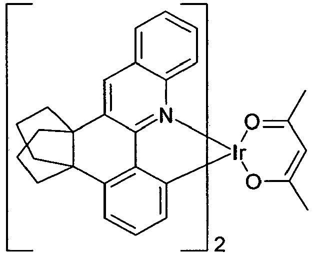 | 77 % |
| | | N,N,-trans, C₂ | |
| Ir403 | [Ir(L17)₂Cl]₂ 123-54-6 | 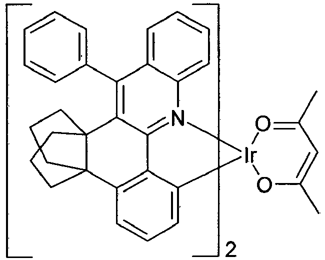 | 68% |
| | | N,N,-trans, C₂ | |
| Ir404 | [Ir(L16)₂Cl]₂ 1118-71-4 | 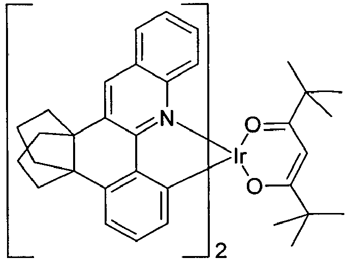 | 76 % |
| | | N,N,-trans, C₂ | |
| Ir405 | [Ir(L17)₂Cl]₂ 1118-71-4 | 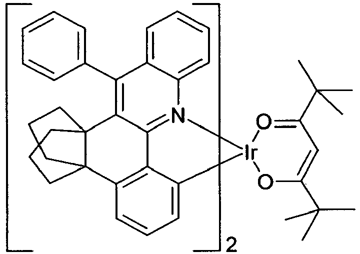 | 69 % |
| | | N,N,-trans, C₂ | |
| Ir406 | [Ir(L5)₂Cl]₂ 1137-68-4 | 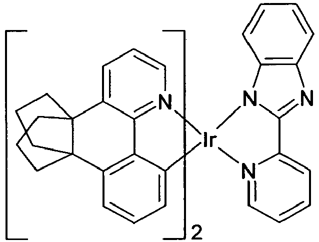 | 71 % |

### 7) Platin-Komplexe vom Typ PtLL' enthaltend nicht o-metallierte Liganden L'

Darstellung analog J. Brooks et al., Inorg. Chem. 2002, 41, 3055. Ein Gemisch aus 20 mmol des Liganden L, 10 mmol K₂PtCl₄, 75 ml 2-Ethoxyethanol und 25 ml Wasser wird 16 h unter Rückfluss erhitzt. Nach Erkalten und Zugabe von 100 ml Wasser saugt man vom ausgefallenen Feststoff ab, wäscht diesen einmal mit 30 ml Wasser und trocknet im Vakuum. Man suspendiert das so erhaltene Platin-Chloro-Dimer der Formel [PtLCl]₂ in 100 ml 2-Ethoxyethanol, gibt 30 mmol der Liganden L' und 50 mmol Natriumcarbonat zu, rührt die Reaktionsmischung 16 h bei 100 °C und engt dann im Vakuum zur Trockene ein. Das so erhaltene Rohprodukt wird an Kieselgel (Lösemittel bzw. deren Gemische, z. B. Ethylacetat, Dichlormethan, THF, Toluol, n-Heptan, Cyclohexan) chromatographiert bzw. umkristallisiert und wie unter 1) Variante A beschrieben fraktioniert sublimiert.

| **Bsp.** | **Ligand L** | **Pt-Komplex** | **Ausbeute** |
|---|---|---|---|
| | **Ligand L'** | | |
| Pt001 | L5 | 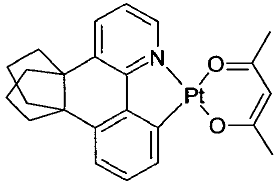 | 36% |
| | 123-54-6 | | |
| Pt002 | L16 | 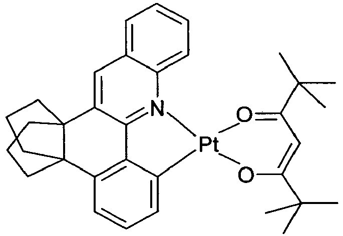 | 44 % |
| | 1118-71-4 | | |
| Pt003 | L16 | 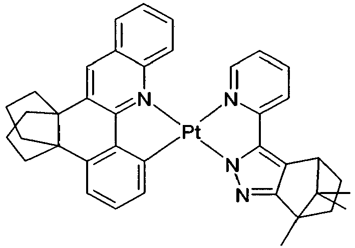 | 51 % |
| | 867291-13-2 | | |

### Vergleich der thermischen Stabilität

Zum Vergleich der thermischen Stabilität werden je 50 mg der Verbindungen Ir(L1)₃ (Vergleichsbeispiel gemäß EP 1400514) und Ir(L5)₃ sowie Ir200 (Vergleichsbeispiel) und Ir202 unter Vakuum (p ca. 10⁻⁵ mbar) in Glasampullen abgeschmolzen und dann 14 Tage unter Lichtausschluss auf 350 °C erhitzt. Nach beendeter thermischer Auslagerung werden die Proben mittels optischer Begutachtung mit dem Auge und HPLC-MS auf Veränderungen untersucht. Die erfindungsgemäßen Komplexe Ir(L5)₃ sowie Ir202 sehen nach beendeter thermischer Auslagerung, optisch mit dem Auge betrachtet, unverändert aus. Mit Hilfe der HPLC-MS können keine Veränderungen detektiert werden. Die Komplexe Ir(L1)₃ und Ir200 (Vergleichsbeispiele) sind orange-braun verfärbt. Mit Hilfe der HPLC-MS kann eine Zersetzung in der Größenordung von ca. 0.5 % (mehrere Spezies) detektiert werden. Die Masse der Zersetzungspeaks (M+ -2H und M+ -4H) lässt vermuten, dass ein Teil der Dihydrobenzo[h]chinolin-Liganden durch Wasserstoffabspaltung (Dehydrierung) zu Benzo[h]-chinolin-Liganden umgewandelt wurde. Diese thermische Zersetzung ist für den OLED-Bau höchst problematisch, da die durch Dehydrierung entstehenden Komplexe ebenfalls emissiv in der OLED sind, jedoch deutlich längerwellig emittieren als die Ausgangskomplexe, so dass es im Laufe des Anlagenbetriebs zu Farbverschiebungen der OLED-Bauteile kommen kann.

### Vergleich der photochemischen Stabilität

1 mmolare Lösungen von Ir(L1)₃ (Vergleichsbeispiel) und Ir(L5)₃ in Toluol werden 10 h an Luft und Tageslicht in Reagenzgläsern stehen gelassen. Danach werden die Proben mittels Dünnschichtchromarographie (Kieselgelplatten, Laufmittel Toluol:DCM 9:1) untersucht. Ir(L5)₃ zeigt keine Veränderung im Vergleich zur Originalprobe. Das Chromatogramm von Ir(L1)₃ (Vergleichsbeispiel) zeigt mehrere Nebenkomponenten (Startfleck und zwei Spots mit geringerem Rf als die Probe), die im Originalmaterial nicht zu beobachten sind. Die Instabilität des Vergleichskomplexes ist nach NMR-Studien auf die Reaktion der CH₂-Gruppen des Dihydrobenzo[h]-chinolin-Liganden mit durch Triplettsensibilisierung erzeugtem Singulett-Sauerstoff, unter Bildung von Oxidationsprodukten (Hydroperoxide, Alkohole, Ketone), zurückzuführen. Diese Oxidationsprodukte wirken sich negativ auf die Eigenschaften (z.B. die Bauteillebensdauer) von aus Lösung unter üblichen Laborbedingunen prozessierten OLED-Bauteilen aus.

### Herstellung der OLEDs

### 1) Vakuum-prozessierte Devices

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Glasplättchen, mit strukturiertem ITO (50 nm, Indium-Zinn-Oxid) bilden die Substrate, auf welche die OLEDs aufgebracht werden. Die OLEDs haben prinzipiell folgenden Schichtaufbau: Substrat / Lochtransportschicht 1 (HTL1) bestehend aus HTM dotiert mit 3 % NDP-9 (kommerziell erhältlich von der Fa. Novaled), 20 nm / Lochtransportschicht 2 (HTL2) / optionale Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-verdampfung in einem bestimmten Volumenanteil beigemischt wird. Eine Angabe wie M3:M2:Ir(L1)₃ (55%:35%:10%) bedeutet hierbei, dass das Material M3 in einem Volumenanteil von 55%, M2 in einem Anteil von 35% und Ir(L1)₃ in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 3 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist, also von z.B. 1000 cd/m² auf 500 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Iridium-Verbindungen gemäß Tabelle 4 verwendet. Die Ergebnisse der OLEDs sind in Tabelle 2 zusammengefasst.

**Tabelle 1: Aufbau der OLEDs**

| **Bsp.** | **HTL2 Dicke** | **EBL Dicke** | **EML Dicke** | **HBL Dicke** | **ETL Dicke** |
|---|---|---|---|---|---|
| **Rote OLEDs** | | | | | |
| D-IrR1 Vgl. | HTM 50 nm | --- | M7:M8:IrR1 (60%:35%:5%) 40 nm | ETM1 10 nm | ETM1: ETM2 (50%:50%) 40 nm |
| D-Ir402 | HTM 50 nm | --- | M7:M8:Ir402 (60%:35%:5%) 40 nm | ETM1 10 nm | ETM1:ETM2 (50%:50%) 40 nm |
| D-Ir404 | HTM 50 nm | --- | M7:M8:Ir404 (60%:35%:5%) 40 nm | ETM1 10 nm | ETM1:ETM2 (50%:50%) 40 nm |

| **Gelbe OLEDs** | | | | | |
|---|---|---|---|---|---|
| D-IrY1 Vgl. | HTM 40 nm | --- | M7:M8:IrY1 (62%:30%:8%) 30 nm | ETM1 10 nm | ETM1: ETM2 (50%:50%) 45 nm |
| D-Ir(L1 1)₃ | HTM 40 nm | --- | M7:M8:Ir(L 11)₃ (62%:30%:8%) 30 nm | ETM1 10 nm | ETM1:ETM2 (50%:50%) 45 nm |
| D-Ir204 | HTM 40 nm | --- | M7:M8:Ir204 (62%:30%:8%) 30 nm | ETM1 10 nm | ETM1:ETM2 (50%:50%) 45 nm |
| D-Ir217 | HTM 40 nm | --- | M7:M8:Ir217 (60%:30%:10%) 30 nm | ETM1 10 nm | ETM1:ETM2 (50%:50%) 45 nm |

| **Grüne OLEDs** | | | | | |
|---|---|---|---|---|---|
| D-IrG1 Vgl. | HTM 30 nm | --- | M7:M8:IrG1 (60%:30%:10%) 30 nm | ETM1 10 nm | ETM1:ETM2 (50%:50%) 35 nm |
| D-IrG2 Vgl. | HTM 30 nm | --- | M7:M8:IrG2 (60%:30%:10%) 30 nm | ETM1 10 nm | ETM1:ETM2 (50%:50%) 35 nm |
| D-Ir(L1)₃ Vgl. | HTM 30 nm | --- | M7:M8:Ir(L 1)₃ (60%:30%:10%) 30 nm | ETM1 10 nm | ETM1:ETM2 (50%:50%) 35 nm |
| D-Ir(L2)₃ Vgl. | HTM 30 nm | --- | M7:M8:Ir(L2)₃ (60%:30%:10%) 30 nm | ETM1 10 nm | ETM1:ETM2 (50%:50%) 35 nm |
| D-Ir200 Vgl. | HTM 30 nm | --- | M7:M8:Ir200 (60%:30%:10%) 30 nm | ETM1 10 nm | ETM1:ETM2 (50%:50%) 35 nm |
| D-Ir(L5)₃ | HTM 30 nm | --- | M7:M8:Ir(L5)₃ (60%:30%:10%) 30 nm | ETM1 10 nm | ETM1:ETM2 (50%:50%) 35 nm |
| D-Ir(L6)₃ | HTM 30 nm | --- | M7:M8:Ir(L6)₃ (60%:30%:10%) 30 nm | ETM1 10 nm | ETM1:ETM2 (50%:50%) 35 nm |
| D-Ir(L9)₃ | HTM 30 nm | --- | M7:M8:Ir(L9)₃ (60%:30%:10%) 30 nm | ETM1 10 nm | ETM1:ETM2 (50%:50%) 35 nm |
| D-Ir203 | HTM 30 nm | --- | M7:M8:Ir203 (60%:30%:10%) 30 nm | ETM1 10 nm | ETM1:ETM2 (50%:50%) 35 nm |
| D-Ir205 | HTM 30 nm | --- | M7:M8:Ir205 (60%:30%:10%) 30 nm | ETM1 10 nm | ETM1:ETM2 (50%:50%) 35 nm |
| D-Ir206 | HTM 30 nm | --- | M7:M8:Ir206 (40%:50%:10%) 30 nm | ETM1 10 nm | ETM1:ETM2 (50%:50%) 35 nm |
| D-Ir211 | HTM 30 nm | --- | M7:M8:Ir211 (60%:30%:10%) 30 nm | ETM1 10 nm | ETM1:ETM2 (50%:50%) 35 nm |
| D-Ir400 | HTM 30 nm | --- | M7:M8:Ir400 (60%:30%:10%) 30 nm | ETM1 10 nm | ETM1:ETM2 (50%:50%) 35 nm |
| D-Pt100 | HTM 30 nm | --- | M7:M8:Pt100 (40%:50%:10%) 30 nm | ETM1 10 nm | ETM1:ETM2 (50%:50%) 35 nm |

| **Blaue OLEDs** | | | | | |
|---|---|---|---|---|---|
| D-Ir(L14)₃ | HTM 30 nm | EBM 10 nm | M1:M4:Ir(L14)₃ (60%:35%:5%) 25 nm | HBM 10 nm | ETM1:ETM2 (50%:50%) 15 nm |
| D-Ir218 | HTM 30 nm | EBM 10 nm | M1:M4:Ir218 (60%:35%:5%) 25 nm | HBM 10 nm | ETM1:ETM2 (50%:50%) 15 nm |

**Tabelle 2: Ergebnisse der Vakuum-prozessierten OLEDs**

| **Bsp.** | **EQE (%) 1000 cd/m²** | **Spannung (V) 1000 cd/m²** | **CIE x/y 1000 cd/m²** | **LD80 (h) 1000 cd/m²** |
|---|---|---|---|---|
| **Rote OLEDs** | | | | |
| D-IrR1 | 16.8 | 2.8 | 0.65/0.35 | 14000 |
| D-Ir402 | 16.5 | 3.0 | 0.63/0.36 | 18000 |
| D-Ir404 | 17.2 | 2.9 | 0.64/0.36 | 21000 |

| **Gelbe OLEDs** | | | | |
|---|---|---|---|---|
| D-IrY1 | 22.3 | 3.0 | 0.44/0.54 | 30000 |
| D-Ir(L11)₃ | 19.8 | 2.9 | 0.39/0.57 | 23000 |
| D-Ir204 | 23.4 | 2.9 | 0.46/0.53 | 43000 |
| D-Ir217 | 20.9 | 2.9 | 0.46/0.53 | 42000 |

| **Grüne OLEDs** | | | | |
|---|---|---|---|---|
| D-IrG1 | 18.0 | 3.4 | 0.32/0.64 | 9000 |
| D-IrG2 | 18.3 | 3.3 | 0.33/0.63 | 23000 |
| D-Ir(L1)₃ | 19.1 | 3.3 | 0.34/0.62 | 15000 |
| D-Ir(L2)₃ | 18.9 | 3.4 | 0.35/0.63 | 12000 |
| D-Ir200 | 19.2 | 3.3 | 0.34/0.62 | 11000 |
| D-Ir(L5)₃ | 20.3 | 3.3 | 0.32/0.64 | 29000 |
| D-Ir(L6)₃ | 20.7 | 3.3 | 0.32/0.65 | 35000 |
| D-Ir(L9)₃ | 20.5 | 3.5 | 0.33/0.64 | 27000 |
| D-Ir203 | 20.0 | 3.3 | 0.32/0.64 | 20000 |
| D-Ir205 | 20.1 | 3.2 | 0.33/0.63 | 28000 |
| D-Ir206 | 23.3 | 3.2 | 0.32/0.65 | 29000 |
| D-Ir211 | 22.2 | 3.3 | 0.32/0.64 | 33000 |
| D-Ir400 | 23.1 | 3.5 | 0.35/0.63 | 20000 |
| D-Pt100 | 19.1 | 3.6 | 0.31/0.62 | --- |

| **Blaue OLEDs** | | | | |
|---|---|---|---|---|
| | **EQE (%) 1000 cd/m²** | **Spannung (V) 1000 cd/m²** | **CIE x/y 1000 cd/m²** | **LD50 (h) 1000 cd/m²** |
| D-Ir(L14)₃ | 21.7 | 4.8 | 0.16/0.30 | 1400 |
| D-Ir218 | 23.5 | 4.6 | 0.16/0.31 | 1600 |

### 2) Lösungs-prozessierte Devices aus löslichen Funktionsmaterialien

Die erfindungsgemäßen Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / PEDOT (80 nm) / Interlayer (80 nm) / Emissionsschicht (80 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum als Pufferschicht eine 80 nm Schicht PEDOT (PEDOT ist ein Polythiophen-Derivat (Baytron P VAI 4083sp.) von H. C. Starck, Goslar, das als wässrige Dispersion geliefert wird) durch Spin-Coating aufgebracht. Die benötigte Spinrate hängt vom Verdünnungsgrad und der spezifischen Spin-Coater-Geometrie ab (typisch für 80 nm: 4500 rpm). Um Restwasser aus der Schicht zu entfernen, werden die Substrate für 10 Minuten bei 180 °C auf einer Heizplatte ausgeheizt. Die verwendete Interlayer dient der Lochinjektion, in diesem Fall wird HIL-012 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Emitter zusammen mit den Matrixmaterialien in Toluol gelöst. Der typische Feststoffgehalt solcher Lösungen liegt zwischen 16 und 25 g/L, wenn, wie hier, die für eine Device typische Schichtdicke von 80 nm mittels Spincoating erzielt werden soll. Die lösungsprozessierten Devices vom Typ1 enthalten eine Emissionsschicht aus (Polystyrol) : M5 : M6 : Ir(L)₃ (20%:30%:40%:10%), die vom Typ2 enthalten eine Emissionsschicht aus (Polystyrol): M5 : M6 : Ir(L204)₃: Ir(L)₃ (20%:20%:40%:15%:5%). Die Emissionsschicht wird in einer Inertgasatmosphäre, im vorliegenden Fall Argon, aufgeschleudert und 30 min bei 130 °C ausgeheizt. Zuletzt wird eine Kathode aus Barium (5 nm) und dann Aluminium (100 nm) (hochreine Metalle von Aldrich, besonders Barium 99.99 % (Best-Nr. 474711); Aufdampfanlagen von Lesker o.a., typischer Aufdampfdruck 5 x 10⁻⁶ mbar) aufgedampft. Optional kann zunächst eine Lockblockierschicht und dann eine Eletronentransportschicht und dann erst die Kathode (z.B. Al oder LiF/Al) im Vakuum aufgedampft werden. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 3 fasst die erhaltenen Daten zusammen.

**Tabelle 3: Ergebnisse mit aus Lösung prozessierten Materialien**

| **Bsp.** | **Emitter Device** | **EQE (%) 1000 cd/m²** | **Spannung (V) 1000 cd/m²** | **CIE x/y 1000 cd/m²** |
|---|---|---|---|---|
| **Rote OLEDs** | | | | |
| D-Sol001 | Ir405 | 16.3 | 4.0 | 0.64/0.36 |
| | Typ2 | | | |

| **Grüne OLEDs** | | | | |
|---|---|---|---|---|
| D-Sol100 | Ir207 | 20.3 | 5.1 | 0.59/0.39 |
| | Typ1 | | | |
| D-Sol-101 | Ir211 | 20.7 | 5.3 | 0.62/0.34 |
| | Typ1 | | | |

**Tabelle 4: Strukturformeln der verwendeten Materialien**

| | |
|---|---|
| 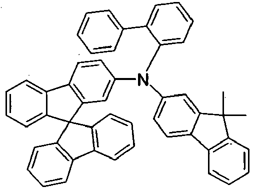 | 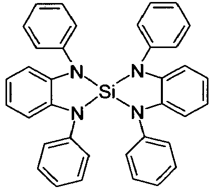 |
| HTM | EBM = M10 |
| 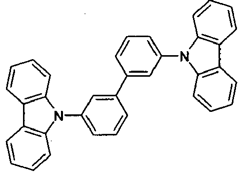 | 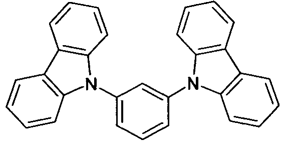 |
| M1 | M2 |
| 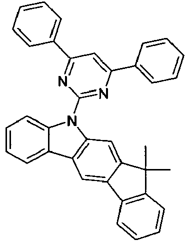 | 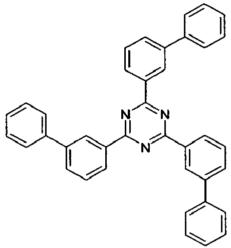 |
| M3 = HBM2 | M4=HBM1 |
| 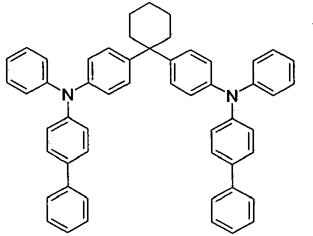 | 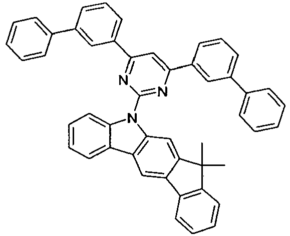 |
| M5 | M6 |
| 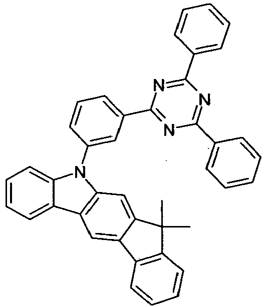 | 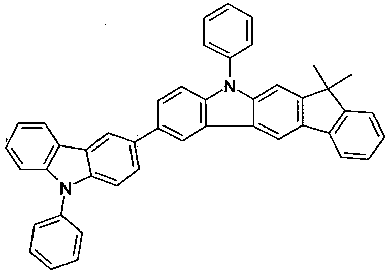 |
| M7 | M8 |
| 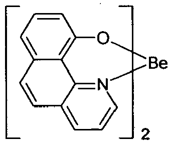 | |
| 148896-39-3 | |
| M9 | |
| 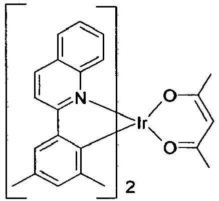 | 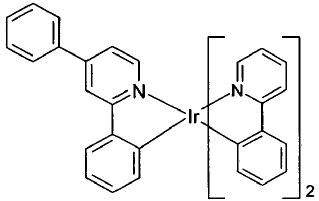 |
| 1056874-46-4 | 1215281-24-5 |
| IrR1 | IrY1 |
| 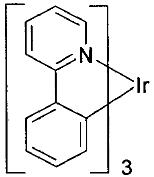 | 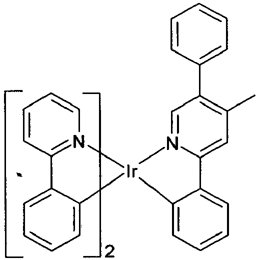 |
| 693794-98-8 | 1215692-34-4 |
| IrG1 | IrG2 |
| 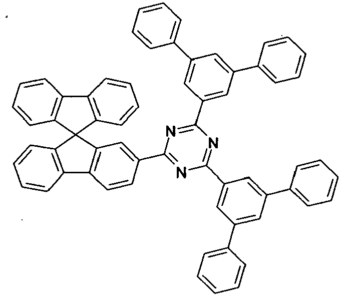 | 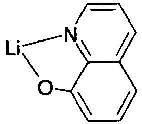 |
| ETM1 | ETM2 |

## Patentansprüche

1. Verbindung gemäß Formel (1),
M(L)ₙ(L')ₘ Formel (1)
welche eine Teilstruktur M(L)ₙ der Formel (2) enthält: 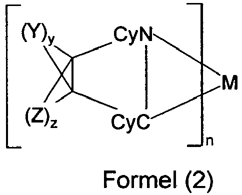 wobei für die verwendeten Symbole und Indizes gilt:
M ist Iridium oder Platin;
CyC ist eine Struktur der Formel (CyC): 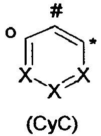 wobei die Gruppe an der durch # gekennzeichneten Position an CyN bindet und an der durch * gekennzeichneten Position an M koordiniert und die bicyclische Gruppe enthaltend Y und Z an der durch o gekennzeichneten Position gebunden ist;
CyN ist eine Struktur der Formel (CyN): 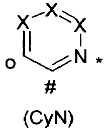 wobei die Gruppe an der durch # gekennzeichneten Position an CyC bindet und an der durch * gekennzeichneten Position an M koordiniert und die bicyclische Gruppe enthaltend Y und Z an der durch o gekennzeichneten Position gebunden ist;
X ist bei jedem Auftreten gleich oder verschieden CR oder N, mit der Maßgabe, dass maximal zwei Symbole X in CyC und maximal zwei Symbole X in CyN für N stehen;
Y ist bei jedem Auftreten gleich oder verschieden CR₂ oder O mit der Maßgabe, dass für y > 1 keine Sauerstoffatome direkt aneinander gebunden sind;
Z ist bei jedem Auftreten gleich oder verschieden CR₂ oder O mit der Maßgabe, dass für z > 1 keine Sauerstoffatome direkt aneinander gebunden sind;
R ist bei jedem Auftreten gleich oder verschieden H, D, F, Cl, Br, I, N(R¹)₂, CN, NO₂, OH, COOR¹, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R¹ substituiert sein kann, wobei eine oder mehrere nicht benachbarte CH₂-Gruppen durch R¹C=CR¹, R¹C=N, C≡C, Si(R¹)₂, C=O, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann, oder eine Aralkyl- oder Heteroaralkylgruppe mit 5 bis 40 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei benachbarte Reste R auch miteinander ein mono- oder polycyclisches, aliphatisches, aromatisches oder heteroaromatisches Ringsystem bilden;
R¹ ist bei jedem Auftreten gleich oder verschieden H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR², R²C=N, C≡C, Si(R²)₂, C=O, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R² substituiert sein kann; dabei können zwei oder mehrere benachbarte Reste R¹ miteinander ein mono- oder polycyclisches, aliphatisches, aromatisches oder heteroaromatisches Ringsystem bilden;
R² ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können; dabei können zwei oder mehrere Substituenten R² auch miteinander ein mono- oder polycyclisches Ringsystem bilden;
L' ist gleich oder verschieden bei jedem Auftreten ein Ligand;
y ist bei jedem Auftreten gleich oder verschieden 1, 2, 3, 4, 5, 6, oder 7;
z ist bei jedem Auftreten gleich oder verschieden 1, 2, 3, 4, 5, 6 oder 7;
n ist 1, 2 oder 3;
m ist 0, 1, 2, 3 oder 4;
dabei können auch mehrere Liganden L miteinander oder L mit L' über eine Einfachbindung oder eine bivalente oder trivalente Brücke verknüpft sein und so ein tridentates, tetradentates, pentadentates oder hexadentates Ligandensystem aufspannen; weiterhin kann auch ein Substituent R zusätzlich an M koordinieren.

2. Verbindung nach Anspruch 1, **dadurch gekennzeichnet, dass** die Gruppe der Formel (CyC) ausgewählt ist aus den Strukturen der Formeln (CyC-1) bis (CyC-5) und dass die Gruppe der Formel (CyN) ausgewählt ist aus den Strukturen der Formeln (CyN-1) bis (CyN-3), 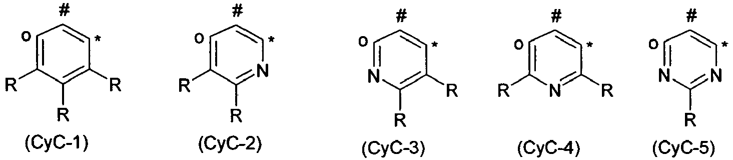 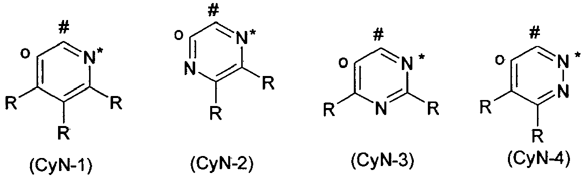 wobei R die in Anspruch 1 genannten Bedeutungen aufweist.

3. Verbindung nach Anspruch 1 oder 2, **dadurch gekennzeichnet, dass** die Gruppe der Formel (CyC) ausgewählt ist aus den Strukturen der Formeln (CyC-1a) bis (CyC-1k) und (CyC-2a) bis (CyC-5a) und dass die Gruppe der Formel (CyN) ausgewählt ist aus den Strukturen der Formeln (CyN-1a) bis (CyN-1c) und (CyN-2a), 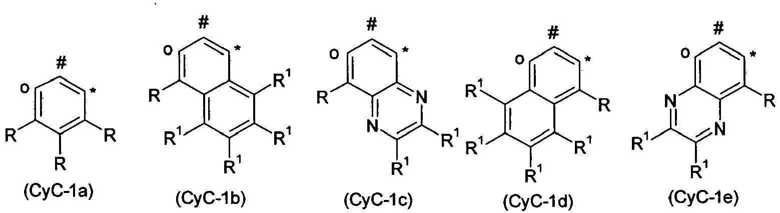 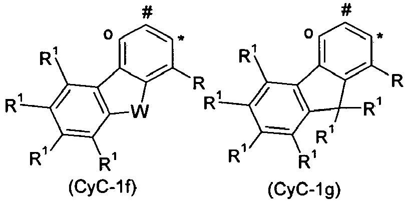 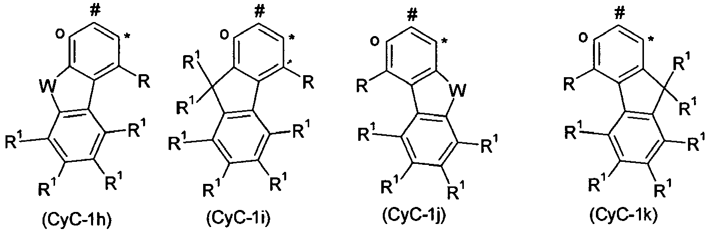 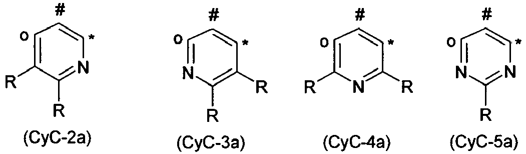 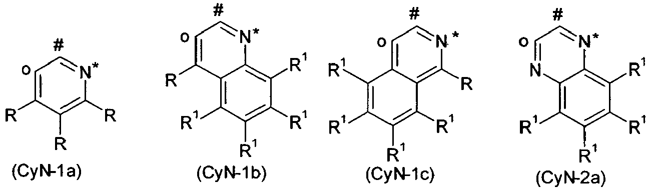 wobei die verwendeten Symbole die in den Ansprüchen 1 und 2 genannten Bedeutungen aufweisen und die Reste R und R¹ kein aromatisches oder heteroaromatisches Ringsystem miteinander bilden und W bei jedem Auftreten gleich oder verschieden für NR¹, O oder S steht.

4. Verbindung nach einem oder mehreren der Ansprüche 1 bis 3,
**dadurch gekennzeichnet, dass** die Struktur der Formel (2) eine Struktur der Formel (2a) darstellt, 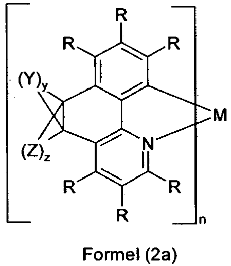 wobei die verwendeten Symbole und Indizes die in Anspruch 1 genannten Bedeutungen aufweisen.

5. Verbindung nach einem oder mehreren der Ansprüche 1 bis 4,
**dadurch gekennzeichnet, dass** Y und Z gleich oder verschieden bei jedem Auftreten für CR₂ stehen.

6. Verbindung nach einem oder mehreren der Ansprüche 1 bis 5,
**dadurch gekennzeichnet, dass** die Indizes y und z gleich oder verschieden bei jedem Auftreten für 1, 2, 3 oder 4 stehen.

7. Verbindung nach einem oder mehreren der Ansprüche 1 bis 6,
**dadurch gekennzeichnet, dass** der Rest R, welcher für X = CR an das entsprechende Kohlenstoffatom gebunden ist, bei jedem Auftreten gleich oder verschieden ausgewählt ist aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei bevorzugt benachbarte Rest R oder R mit R¹ auch miteinander ein Ringsystem bilden,
und dass der Rest R, der für Y und/oder Z = CR₂ an das entsprechende Kohlenstoffatom gebunden ist, gleich oder verschieden bei jedem Auftreten ausgewählt ist aus der Gruppe bestehend aus H, D, F, einer geradkettigen Alkylgruppe mit 1 bis 10 C-Atomen, die mit einem oder mehreren Resten R¹ substituiert sein kann, einer verzweigten oder cyclischen Alkylgruppe mit 3 bis 10 C-Atomen, die mit einem oder mehreren Resten R¹ substituiert sein kann, oder einem aromatischen oder heteroaromatischen Ringsystem mit 6 bis 13 aromatischen Ringatomen, das jeweils durch einen oder mehrere Reste R¹ substituiert sein kann; dabei können zwei oder mehrere Reste R auch miteinander ein Ringsystem bilden.

8. Verbindung nach einem oder mehreren der Ansprüche 1 bis 7,
**dadurch gekennzeichnet, dass** L' ein bidentater, monoanionischer Ligand ist.

9. Verbindung nach Anspruch 8, **dadurch gekennzeichnet, dass** L' ausgewählt ist aus 1,3-Diketonaten abgeleitet von 1,3-Diketonen, 3-Ketonaten abgeleitet von 3-Ketoestern, Carboxylaten abgeleitet von Aminocarbonsäuren sowie Liganden, die mit M einen cyclometallierten Fünfring oder Sechsring mit mindestens einer Metall-Kohlenstoff-Bindung aufweisen.

10. Verfahren zur Herstellung einer Verbindung nach einem oder mehreren der Ansprüche 1 bis 9 durch Umsetzung der freien Liganden L und gegebenenfalls L' mit Metallalkoholaten der Formel (58), mit Metallketoketonaten der Formel (59), mit Metallhalogeniden der Formel (60), mit dimeren Metallkomplexen der Formel (61) oder mit Metallkomplexen der Formel (62) oder mit Metallverbindungen, die sowohl Alkoholat- und/oder Halogenid- und/oder Hydroxy- wie auch Ketoketonatreste tragen, 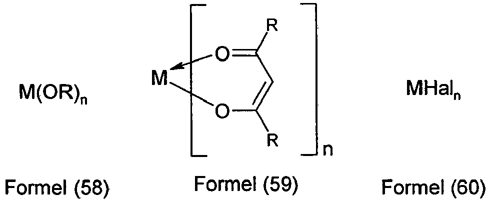 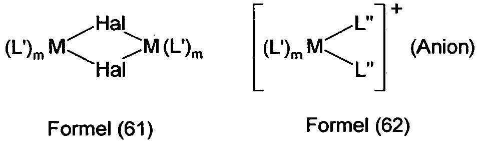 wobei die verwendeten Symbole und Indizes die in Anspruch 1 angegebenen Bedeutungen haben, Hal = F, Cl, Br oder I ist, L" für einen Alkohol oder ein Nitril steht und (Anion) ein nicht-koordinierendes Anion ist.

11. Oligomer, Polymer oder Dendrimer enthaltend eine oder mehrere Verbindungen nach einem oder mehreren der Ansprüche 1 bis 9, wobei ein oder mehrere Bindungen der Verbindung zum Polymer, Oligomer oder Dendrimer vorhanden sind.

12. Formulierung, enthaltend eine Verbindung nach einem oder mehreren der Ansprüche 1 bis 9 oder ein Oligomer, Polymer oder Dendrimer nach Anspruch 11 und mindestens eine weitere Verbindung.

13. Verbindung der Formel (63), 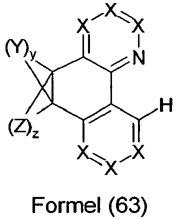 wobei die verwendeten Symbole und Indizes die in Anspruch 1 genannten Bedeutungen aufweisen.

14. Verwendung einer Verbindung nach einem oder mehreren der Ansprüche 1 bis 9 oder 13 oder eines Oligomers, Polymers oder Dendrimers nach Anspruch 11 in einer elektronischen Vorrichtung oder zur Erzeugung von Singulett-Sauerstoff oder in der Photokatalyse.

15. Elektronische Vorrichtung enthaltend eine Verbindung nach einem oder mehreren der Ansprüche 1 bis 9 oder 13 oder ein Oligomer, Polymer oder Dendrimer nach Anspruch 11 .

16. Elektronische Vorrichtung nach Anspruch 15, wobei es sich um eine organische Elektrolumineszenzvorrichtung handelt, **dadurch gekennzeichnet, dass** die Verbindung nach einem oder mehreren der Ansprüche 1 bis 9 als emittierende Verbindung in einer oder mehreren emittierenden Schichten eingesetzt wird.

## Claims

1. Compound of formula (1)
M(L)ₙ(L')ₘ Formula (1)
containing a substructure M(L)ₙ of the formula (2): 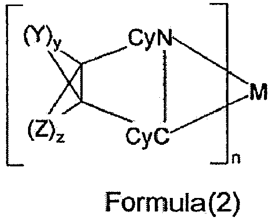 where the symbols and indices used are as follows:
M is iridium or platinum;
CyC is a structure of the formula (CyC): 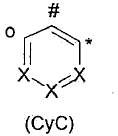
where the group binds to CyN at the position identified by # and coordinates to M at the position identified by * and the bicyclic group containing Y and Z is bonded at the position identified by o;
CyN is a structure of the formula (CyN): 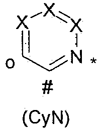
where the group binds to CyC at the position identified by # and coordinates to M at the position identified by * and the bicyclic group containing Y and Z is bonded at the position identified by o;
X is the same or different at each instance and is CR or N, with the proviso that not more than two symbols X in CyC and not more than two symbols X in CyN are N;
Y is the same or different at each instance and is CR₂ or O, with the proviso that, when y > 1, no oxygen atoms are bonded directly to one another;
Z is the same or different at each instance and is CR₂ or O, with the proviso that, when z > 1, no oxygen atoms are bonded directly to one another;
R is the same or different at each instance and is H, D, F, Cl, Br, I, N(R¹)₂, CN, NO₂, OH, COOR¹, C(=O)N(R¹)₂, Si(R¹)₃, B(OR¹)₂, C(=O)R¹, P(=O)(R¹)₂, S(=O)R¹, S(=O)₂R¹, OSO₂R¹, a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, each of which may be substituted by one or more R¹ radicals, where one or more nonadjacent CH₂ groups may be replaced by R¹C=CR¹, R¹C=N, C≡C, Si(R¹)₂, C=O, NR¹, O, S or CONR¹ and where one or more hydrogen atoms may be replaced by D, F, Cl, Br, I or CN, or an aromatic or heteroaromatic ring system which has 5 to 40 aromatic ring atoms and may be substituted in each case by one or more R¹ radicals, or an aryloxy or heteroaryloxy group which has 5 to 40 aromatic ring atoms and may be substituted by one or more R¹ radicals, or an aralkyl or heteroaralkyl group which has 5 to 40 aromatic ring atoms and may be substituted by one or more R¹ radicals, or a diarylamino group, diheteroarylamino group or arylheteroarylamino group which has 10 to 40 aromatic ring atoms and may be substituted by one or more R¹ radicals; at the same time, two adjacent R radicals together may also form a mono- or polycyclic, aliphatic, aromatic or heteroaromatic ring system;
R¹ is the same or different at each instance and is H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, each of which may be substituted by one or more R² radicals, where one or more nonadjacent CH₂ groups may be replaced by R²C=CR², R²C=N, C≡C, Si(R²)₂, C=O, NR², O, S or CONR² and where one or more hydrogen atoms may be replaced by D, F, Cl, Br, I, CN or NO₂, or an aromatic or heteroaromatic ring system which has 5 to 40 aromatic ring atoms and may be substituted in each case by one or more R² radicals, or an aryloxy or heteroaryloxy group which has 5 to 40 aromatic ring atoms and may be substituted by one or more R² radicals, or an aralkyl or heteroaralkyl group which has 5 to 40 aromatic ring atoms and may be substituted by one or more R² radicals, or a diarylamino group, diheteroarylamino group or arylheteroarylamino group which has 10 to 40 aromatic ring atoms and may be substituted by one or more R² radicals; at the same time, two or more adjacent R¹ radicals together may form a mono- or polycyclic, aliphatic, aromatic or heteroaromatic ring system;
R² is the same or different at each instance and is H, D, F or an aliphatic, aromatic and/or heteroaromatic organic radical having 1 to 20 carbon atoms, in which one or more hydrogen atoms may also be replaced by F; at the same time, two or more R² substituents together may also form a mono- or polycyclic ring system;
L' is the same or different at each instance and is a ligand;
y is the same or different at each instance and is 1, 2, 3, 4, 5, 6 or 7;
z is the same or different at each instance and is 1, 2, 3, 4, 5, 6 or 7;
n is 1, 2 or 3;
m is 0, 1, 2, 3 or 4;
at the same time, it is also possible for two or more ligands L to be joined together or for L to be joined to L' by a single bond or a bivalent or trivalent bridge, thus forming a tridentate, tetradentate, pentadentate or hexadentate ligand system; in addition, it is also possible for a substituent R to additionally coordinate to M.

2. Compound according to Claim 1, **characterized in that** the group of the formula (CyC) is selected from the structures of the formulae (CyC-1) to (CyC-5) and that the group of the formula (CyN) is selected from the structures of the formulae (CyN-1) to (CyN-3) 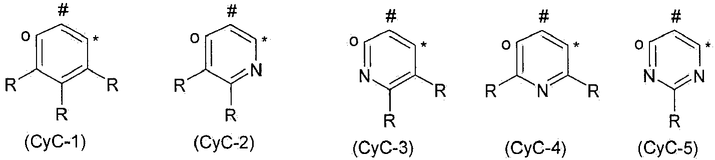 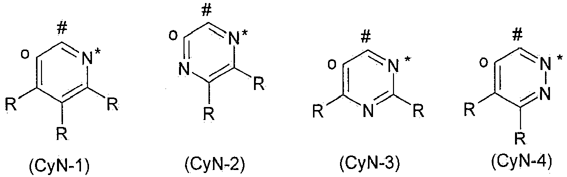 where R has the definitions given in Claim 1.

3. Compound according to Claim 1 or 2, **characterized in that** the group of the formula (CyC) is selected from the structures of the formulae (CyC-1a) to (CyC-1k) and (CyC-2a) to (CyC-5a) and that the group of the formula (CyN) is selected from the structures of the formulae (CyN-1a) to (CyN-1c) and (CyN-2a) 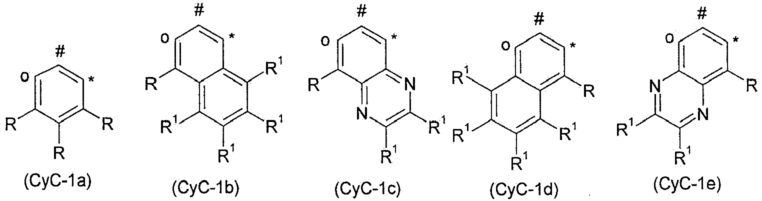 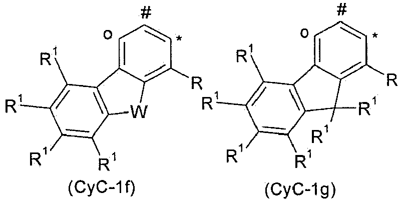 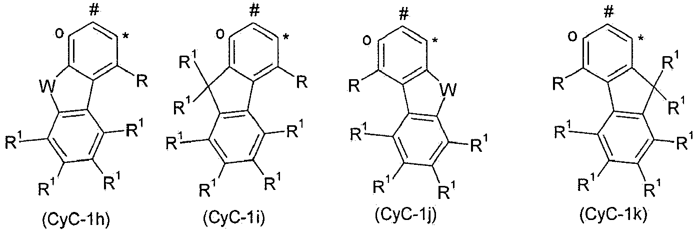 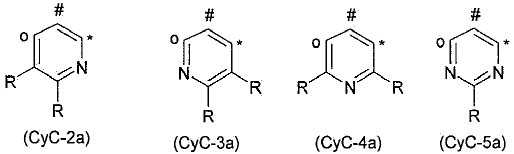 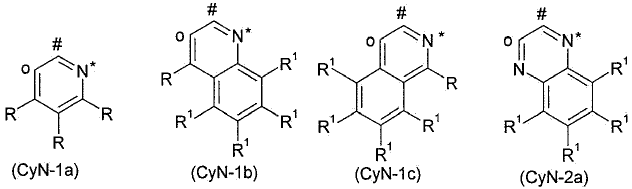 where the symbols used have the definitions given in Claims 1 and 2 and the R and R¹ radicals do not form an aromatic or heteroaromatic ring system with one another and W is the same or different at each instance and is NR¹, O or S.

4. Compound according to one or more of Claims 1 to 3, **characterized in that** the structure of the formula (2) is a structure of the formula (2a) 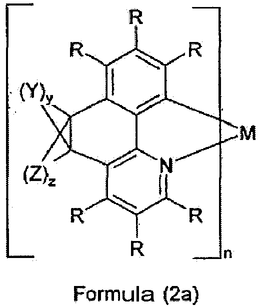 where the symbols and indices used have the definitions given in Claim 1.

5. Compound according to one or more of Claims 1 to 4, **characterized in that** Y and Z are the same or different at each instance and are CR₂.

6. Compound according to one or more of Claims 1 to 5, **characterized in that** the indices y and z are the same or different at each instance and are 1, 2, 3 or 4.

7. Compound according to one or more of Claims 1 to 6, **characterized in that** the R radical which, when X = CR, is bonded to the corresponding carbon atom is the same or different at each instance and is selected from the group consisting of H, D, F, Br, I, N(R¹)₂, CN, Si(R¹)₃, B(OR¹)₂, C(=O)R¹, a straight-chain alkyl group having 1 to 10 carbon atoms or an alkenyl group having 2 to 10 carbon atoms or a branched or cyclic alkyl group having 3 to 10 carbon atoms, each of which may be substituted by one or more R¹ radicals, where one or more hydrogen atoms may be replaced by D or F, or an aromatic or heteroaromatic ring system which has 5 to 24 aromatic ring atoms and may be substituted in each case by one or more R¹ radicals; at the same time, two preferably adjacent R radicals together or R together with R¹ may also form a ring system,
and **in that** the R radical which, when Y and/or Z = CR₂, is bonded to the corresponding carbon atom is the same or different at each instance and is selected from the group consisting of H, D, F, a straight-chain alkyl group which has 1 to 10 carbon atoms and may be substituted by one or more R¹ radicals, a branched or cyclic alkyl group which has 3 to 10 carbon atoms and may be substituted by one or more R¹ radicals, or an aromatic or heteroaromatic ring system which has 6 to 13 aromatic ring atoms and may be substituted in each case by one or more R¹ radicals; at the same time, two or more R radicals together may also form a ring system.

8. Compound according to one or more of Claims 1 to 7, **characterized in that** L' is a bidentate monoanionic ligand.

9. Compound according to Claim 8, **characterized in that** L' is selected from 1,3-diketonates derived from 1,3-diketones, 3-ketonates derived from 3-keto esters, carboxylates derived from aminocarboxylic acids, and ligands which have, with M, a cyclometallated five-membered ring or six-membered ring having at least one metal-carbon bond.

10. Process for preparing a compound according to one or more of Claims 1 to 9 by reacting the free ligands L and optionally L' with metal alkoxides of the formula (58), with metal ketoketonates of the formula (59), with metal halides of the formula (60), with dimeric metal complexes of the formula (61) or with metal complexes of the formula (62) or with metal compounds bearing both alkoxide and/or halide and/or hydroxyl radicals and ketoketonate radicals 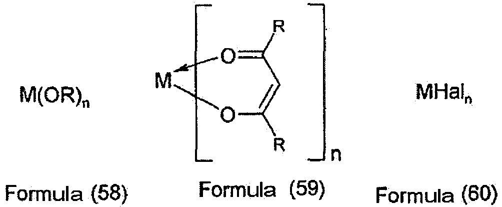 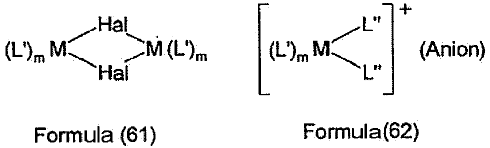 where the symbols and indices used have the definitions given in Claim 1, Hal = F, Cl, Br or I, L'' is an alcohol or a nitrile and (Anion) is a non-coordinating anion.

11. Oligomer, polymer or dendrimer containing one or more compounds according to one or more of Claims 1 to 9, wherein one or more bonds of the compound to the polymer, oligomer or dendrimer are present.

12. Formulation comprising a compound according to one or more of Claims 1 to 9 or an oligomer, polymer or dendrimer according to Claim 11 and at least one further compound.

13. Compound of the formula (63) 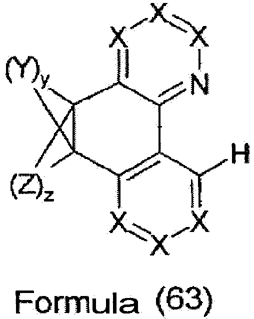 where the symbols and indices used have the definitions given in Claim 1.

14. Use of a compound according to one or more of Claims 1 to 9 or 13, or of an oligomer, polymer or dendrimer according to Claim 11, in an electronic device or for generation of singlet oxygen or in photocatalysis.

15. Electronic device comprising a compound according to one or more of Claims 1 to 9 or 13 or an oligomer, polymer or dendrimer according to Claim 11.

16. Electronic device according to Claim 15 which is an organic electroluminescent device, **characterized in that** the compound according to one or more of Claims 1 to 9 is used as emitting compound in one or more emitting layers.

## Revendications

1. Composé selon la formule (1)
M(L)ₙ(L')ₘ Formule (1)
qui contient une structure partielle M(L)ₙ de formule (2) : 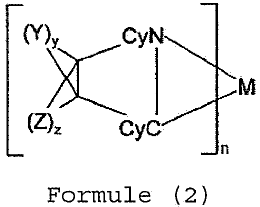 les symboles et indices utilisés ayant les significations suivantes :
M représente l'iridium ou le platine ;
CyC représente une structure de formule (CyC) : 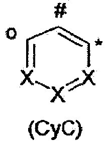
le groupe étant relié à CyN à la position **caractérisée par** # et coordonné à M à la position **caractérisée par** *, et le groupe bicyclique contenant Y et Z étant relié à la position **caractérisée par** o ;
CyN représente une structure de formule (CyN) : 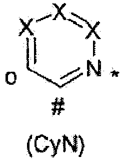
le groupe étant relié à CyC à la position **caractérisée par** # et coordonné à M à la position **caractérisée par** *, et le groupe bicyclique contenant Y et Z étant relié à la position **caractérisée par** o ;
les X représentent à chaque occurrence de manière identique ou différente CR ou N, à condition qu'au plus deux symboles X dans CyC et au plus deux symboles X dans CyN représentent N ;
les Y représentent à chaque occurrence de manière identique ou différente CR₂ ou O, à condition que pour y > 1, aucun des atomes d'oxygène ne soient reliés directement les uns aux autres ;
les Z représentent à chaque occurrence de manière identique ou différente CR₂ ou O, à condition que pour z > 1, aucun des atomes d'oxygène ne soient reliés directement les uns aux autres ;
les R représentent à chaque occurrence de manière identique ou différente H, D, F, Cl, Br, I, N(R¹)₂, CN, NO₂, OH, COOR¹, C(=O)N(R¹)₂, Si(R¹)₃, B(OR¹)₂, C(=O)R¹, P(=O)(R¹)₂, S(=O)R¹, S(=O)₂R¹, OSO₂R¹, un groupe alkyle, alcoxy ou thioalcoxy linéaire de 1 à 20 atomes C, ou un groupe alcényle ou alcynyle de 2 à 20 atomes C, ou un groupe alkyle, alcoxy ou thioalcoxy ramifié ou cyclique de 3 à 20 atomes C, qui peut à chaque fois être substitué avec un ou plusieurs radicaux R¹, un ou plusieurs groupes CH₂ non voisins pouvant être remplacés par R¹C=CR¹, R¹C=N, C≡C, Si(R¹)₂, C=O, NR¹, O, S ou CONR¹, et un ou plusieurs atomes H pouvant être remplacés par D, F, Cl, Br, I ou CN, ou un système cyclique aromatique ou hétéroaromatique contenant 5 à 40 atomes de cycle aromatique, qui peut à chaque fois être substitué par un ou plusieurs radicaux R¹, ou un groupe aryloxy ou hétéroaryloxy contenant 5 à 40 atomes de cycle aromatique, qui peut être substitué par un ou plusieurs radicaux R¹, ou un groupe aralkyle ou hétéroaralkyle contenant 5 à 40 atomes de cycle aromatique, qui peut être substitué par un ou plusieurs radicaux R¹, ou un groupe diarylamino, un groupe dihétéroarylamino ou un groupe arylhétéroarylamino contenant 10 à 40 atomes de cycle aromatique, qui peut être substitué par un ou plusieurs radicaux R¹ ; deux radicaux R voisins pouvant également former l'un avec l'autre un système cyclique mono- ou polycyclique, aliphatique, aromatique ou hétéroaromatique ;
les R¹ représentent à chaque occurrence, de manière identique ou différente, H, D, F, Cl, Br, I, N(R²)₂, CN, NO₂, Si(R²)₃, B(OR²)₂, C(=O)R², P(=O)(R²)₂, S(=O)R², S(=O)₂R², OSO₂R², un groupe alkyle, alcoxy ou thioalcoxy linéaire de 1 à 20 atomes C, ou un groupe alcényle ou alcynyle de 2 à 20 atomes C, ou un groupe alkyle, alcoxy ou thioalcoxy ramifié ou cyclique de 3 à 20 atomes C, qui peut à chaque fois être substitué avec un ou plusieurs radicaux R², un ou plusieurs groupes CH₂ non voisins pouvant être remplacés par R²C=CR², R²C=N, C≡C, Si(R²)₂, C=O, NR², O, S ou CONR², et un ou plusieurs atomes H pouvant être remplacés par D, F, Cl, Br, I, CN ou NO₂, ou un système cyclique aromatique ou hétéroaromatique contenant 5 à 40 atomes de cycle aromatique, qui peut à chaque fois être substitué par un ou plusieurs radicaux R², ou un groupe aryloxy ou hétéroaryloxy contenant 5 à 40 atomes de cycle aromatique, qui peut être substitué par un ou plusieurs radicaux R², ou un groupe aralkyle ou hétéroaralkyle contenant 5 à 40 atomes de cycle aromatique, qui peut être substitué par un ou plusieurs radicaux R², ou un groupe diarylamino, un groupe dihétéroarylamino ou un groupe arylhétéroarylamino contenant 10 à 40 atomes de cycle aromatique, qui peut être substitué par un ou plusieurs radicaux R² ; deux radicaux R¹ voisins ou plus pouvant former les uns avec les autres un système cyclique mono- ou polycyclique, aliphatique, aromatique ou hétéroaromatique ;
les R² représentent à chaque occurrence de manière identique ou différente H, D, F ou un radical organique aliphatique, aromatique et/ou hétéroaromatique contenant 1 à 20 atomes C, dans lequel un ou plusieurs atomes H peuvent également être remplacés par F ; deux substituants R² ou plus pouvant également former les uns avec les autres un système cyclique mono- ou polycyclique ;
les L' représentent à chaque occurrence de manière identique ou différente un ligand ;
les y représentent à chaque occurrence de manière identique ou différente 1, 2, 3, 4, 5, 6 ou 7 ;
les z représentent à chaque occurrence de manière identique ou différente 1, 2, 3, 4, 5, 6 ou 7 ;
n représente 1, 2 ou 3 ;
m représente 0, 1, 2, 3 ou 4 ;
plusieurs ligands L pouvant également être reliés les uns avec les autres ou L avec L' par une simple liaison ou un pont bivalent ou trivalent, et former ainsi un système de ligands tridentate, tétradentate, pentadentate ou hexadentate; un substituant R pouvant également en outre être coordonné à M.

2. Composé selon la revendication 1, **caractérisé en ce que** le groupe de formule (CyC) est choisi parmi les structures des formules (CyC-1) à (CyC-5) et **en ce que** le groupe de formule (CyN) est choisi parmi les structures des formules (CyN-1) à (CyN-3) 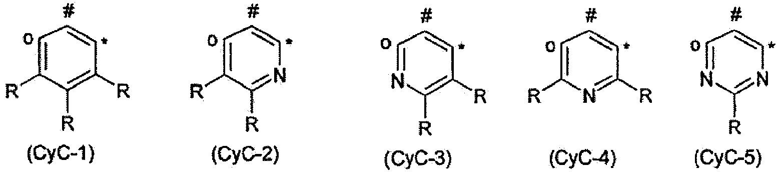 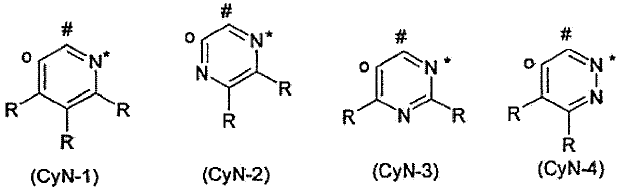 R ayant les significations indiquées dans la revendication 1.

3. Composé selon la revendication 1 ou 2, **caractérisé en ce que** le groupe de formule (CyC) est choisi parmi les structures des formules (CyC-1a) à (CyC-1k) et (CyC-2a) à (CyC-5a) et **en ce que** le groupe de formule (CyN) est choisi parmi les structures des formules (CyN-la) à (CyN-1c) et (CyN-2a) 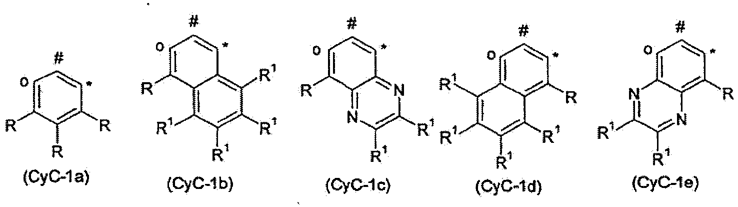 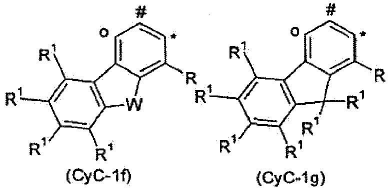 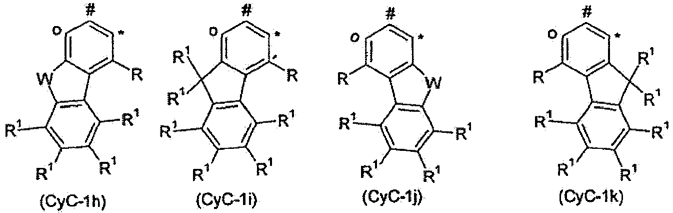 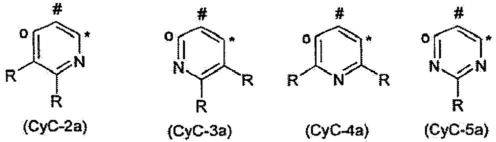 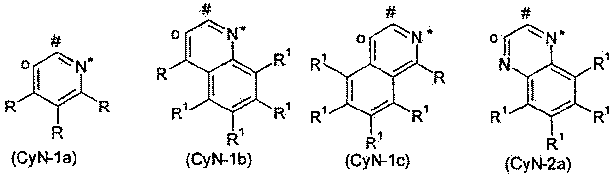 les symboles utilisés ayant les significations indiquées dans les revendications 1 et 2, et les radicaux R et R¹ ne formant pas de système cyclique aromatique ou hétéroaromatique les uns avec les autres, et les W représentant à chaque occurrence de manière identique ou différent NR¹, O ou S.

4. Composé selon une ou plusieurs des revendications 1 à 3, **caractérisé en ce que** la structure de formule(2) est une structure de formule (2a) : 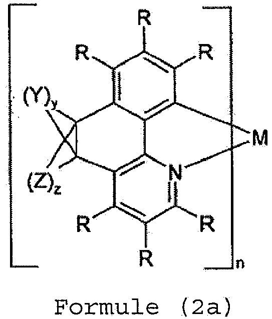 dans laquelle les symboles et les indices utilisés ont les significations indiquées dans la revendication 1.

5. Composé selon une ou plusieurs des revendications 1 à 4, **caractérisé en ce que** Y et Z représentent de manière identique ou différente à chaque occurrence CR₂.

6. Composé selon une ou plusieurs des revendications 1 à 5, **caractérisé en ce que** les indices y et z représentent de manière identique ou différente à chaque occurrence 1, 2, 3 ou 4.

7. Composé selon une ou plusieurs des revendications 1 à 6, **caractérisé en ce que** le radical R, qui pour X = CR est relié à l'atome de carbone correspondant, est choisi à chaque occurrence de manière identique ou différente dans le groupe constitué par H, D, F, Br, I, N(R¹)₂, CN, Si(R¹)₃, B(OR¹)₂, C(=O)R¹, un groupe alkyle linéaire contenant 1 à 10 atomes C, ou un groupe alcényle contenant 2 à 10 atomes C, ou un groupe alkyle ramifié ou cyclique contenant 3 à 10 atomes C, qui peut à chaque fois être substitué avec un ou plusieurs radicaux R¹, un ou plusieurs atomes H pouvant être remplacés par D ou F, ou un système cyclique aromatique ou hétéroaromatique contenant 5 à 24 atomes de cycle aromatique, qui peut à chaque fois être substitué par un ou plusieurs radicaux R¹; deux radicaux R de préférence voisins ou R et R¹ pouvant également former l'un avec l'autre un système cyclique,
et **en ce que** le radical R, qui pour Y et/ou Z = CR₂ est relié à l'atome de carbone correspondant, est choisi de manière identique ou différente à chaque occurrence dans le groupe constitué par H, D, F, un groupe alkyle linéaire de 1 à 10 atomes C, qui peut être substitué avec un ou plusieurs radicaux R¹, un groupe alkyle ramifié ou cyclique de 3 à 10 atomes C, qui peut être substitué avec un ou plusieurs radicaux R¹, ou un système cyclique aromatique ou hétéroaromatique contenant 6 à 13 atomes de cycle aromatique, qui peut à chaque fois être substitué par un ou plusieurs radicaux R¹ ; deux radicaux R ou plus pouvant également former les uns avec les autres un système cyclique.

8. Composé selon une ou plusieurs des revendications 1 à 7, **caractérisé en ce que** L' est un ligand bidentate monoanionique.

9. Composé selon la revendication 8, **caractérisé en ce que** L' est choisi parmi les 1,3-dicétonates dérivés de 1,3-dicétones, les 3-cétonates dérivés de 3-cétoesters, les carboxylates dérivés d'acides aminocarboxyliques, ainsi que les ligands qui comprennent avec M un cycle à cinq chaînons ou un cycle à six chaînons cyclométallisé comprenant au moins une liaison métal-carbone.

10. Procédé de fabrication d'un composé selon une ou plusieurs des revendications 1 à 9 par mise en réaction des ligands libres L et éventuellement L' avec des alcoolates métalliques de formule (58), avec des cétocétonates métalliques de formule (59), avec des halogénures métalliques de formule (60), avec des complexes métalliques dimères de formule (61) ou avec des complexes métalliques de formule (62) ou avec des composés métalliques qui portent aussi bien des radicaux alcoolate et/ou halogénure et/ou hydroxy que cétocétonate, 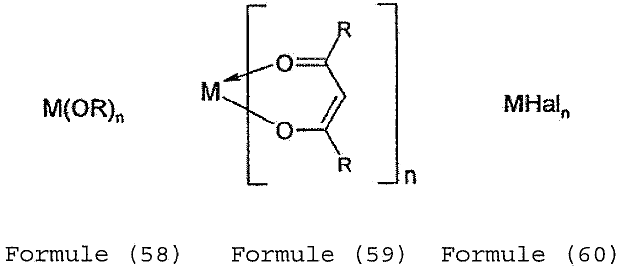 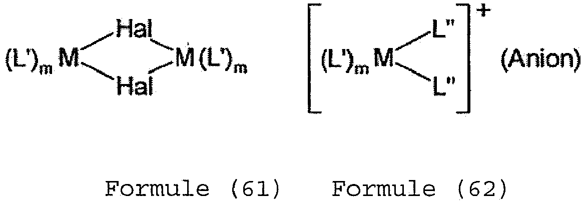 dans lesquelles les symboles et les indices utilisés ont les significations indiquées dans la revendication 1, Hal = F, Cl, Br ou I, L'' représente un alcool ou un nitrile et (anion) est un anion non coordonnant.

11. Oligomère, polymère ou dendrimère contenant un ou plusieurs composés selon une ou plusieurs des revendications 1 à 9, une ou plusieurs liaisons du composé vers le polymère, l'oligomère ou le dendrimère étant présentes.

12. Formulation, contenant un composé selon une ou plusieurs des revendications 1 à 9 ou un oligomère, un polymère ou un dendrimère selon la revendication 11 et au moins un composé supplémentaire.

13. Composé de formule (63) 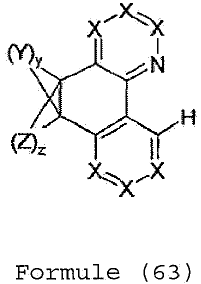 dans laquelle les symboles et les indices utilisés ont les significations indiquées dans la revendication 1.

14. Utilisation d'un composé selon une ou plusieurs des revendications 1 à 9 ou 13 ou d'un oligomère, d'un polymère ou d'un dendrimère selon la revendication 11 dans un dispositif électronique ou pour la génération d'oxygène singulet ou dans la photocatalyse.

15. Dispositif électronique contenant un composé selon une ou plusieurs des revendications 1 à 9 ou 13 ou un oligomère, un polymère ou un dendrimère selon la revendication 11.

16. Dispositif électronique selon la revendication 15, qui est un dispositif électroluminescent organique, **caractérisé en ce que** le composé selon une ou plusieurs des revendications 1 à 9 est utilisé en tant que composé émetteur dans une ou plusieurs couches d'émission.
